# EUROPEAN PATENT APPLICATION

(11) **EP 4 844 740 A1**
(43) Date of publication of application: **25.11.2026**
(21) Application number: 26168586.1
(22) Date of filing: 27.03.2026
(51) Int. Cl.: G09G 3/3233

(54) **DISPLAY APPARATUS AND ELECTRONIC DEVICE INCLUDING THE SAME**

(30) Priority: 22.05.2025 KR 20250066877
(71) Applicant: Samsung Display Co., Ltd., Yongin-si, Gyeonggi-do 17113 (KR)
(72) Inventor: Kim, Jisun, 17113 Yongin-si, Gyeonggi-do (KR); Park, Heejean, 17113 Yongin-si, Gyeonggi-do (KR); Kim, Kwihyun, 17113 Yongin-si, Gyeonggi-do (KR); Chung, Kyunghoon, 17113 Yongin-si, Gyeonggi-do (KR); Kang, Sunmi, 17113 Yongin-si, Gyeonggi-do (KR); Lee, Sehyun, 17113 Yongin-si, Gyeonggi-do (KR)
(74) Representative: Gulde & Partner

(57) **Abstract**

A display apparatus (1) includes a substrate (100), first driving voltage lines (PL1) and second driving voltage lines (PL2), disposed in a display area (DA), first pixel circuits (PCr, PCg) electrically connected to the first driving voltage lines (PL1), second pixel circuits (PCb) electrically connected to the second driving voltage lines (PL2), first, second, and third driving voltage supply lines (VDDL1, VDDL2, VDDL3) disposed in a first peripheral area (PA1), fourth and fifth driving voltage supply lines (VDDL4, VDDL5) disposed in a second peripheral area (PA2) spaced apart from the first peripheral area (PA1), where the first driving voltage supply line (VDDL1) is electrically connected to the third driving voltage supply line (VDDL3), the first driving voltage lines (PL1) are electrically connected to the third driving voltage supply line (VDDL3) and the fourth driving voltage supply line (VDDL4), and the second driving voltage lines (PL2) are electrically connected to the second driving voltage supply line (VDDL2) and the fifth driving voltage supply line (VDDL5).

## Description

### BACKGROUND

### 1. Field

One or more embodiments relate to a display apparatus and an electronic device including the display apparatus, and more particularly, to a display apparatus capable of displaying high-quality images and an electronic device including the display apparatus.

### 2. Description of the Related Art

A display apparatus generally includes a plurality of pixels. Each pixel may include a light-emitting diode that emits light of a certain color, and a pixel circuit configured to control characteristics of the light-emitting diode, such as luminance. The pixel circuit may include transistors, at least one capacitor, and wires.

Recently, display apparatuses have become thinner and lighter, making them applicable to various electronic devices. Consequently, various forms of display apparatuses and electronic devices including the display apparatus are being designed.

### SUMMARY

In display apparatuses of the related art and electronic devices including the display apparatus, a sufficient area for pixels of a specific color may not be secured as pixel sizes become smaller.

One or more embodiments include a display apparatus capable of displaying a high-quality image and an electronic device including the display apparatus. However, such embodiments are examples, and the scope of the disclosure is not limited thereby.

According to one or more embodiments, a display apparatus includes a substrate including a display area, a first peripheral area disposed on one side of the display area, a second peripheral area disposed on the other side of the display area, and a third peripheral area and a fourth peripheral area, wherein the third and fourth peripheral areas connect the first peripheral area and the second peripheral area to each other, first driving voltage lines and second driving voltage lines, which are disposed in the display area and extend in a first direction, first pixel circuits and third pixel circuits, which are disposed in the display area and electrically connected to the first driving voltage lines, second pixel circuits arranged in the display area and electrically connected to the second driving voltage lines, a first driving voltage supply line, a second driving voltage supply line, and a third driving voltage supply line, which are disposed in the first peripheral area and extend in a second direction intersecting the first direction, a fourth driving voltage supply line and a fifth driving voltage supply line, which are disposed in the second peripheral area and extend in the second direction, wherein the first driving voltage supply line is electrically connected to the third driving voltage supply line, the first driving voltage lines are electrically connected to the third driving voltage supply line and the fourth driving voltage supply line, and the second driving voltage lines are electrically connected to the second driving voltage supply line and the fifth driving voltage supply line.

According to an embodiment, the display apparatus may further include second auxiliary driving voltage lines disposed in the display area and extending in the second direction, wherein the second driving voltage lines may be electrically connected to the second auxiliary driving voltage lines.

According to an embodiment, the display apparatus may further include first auxiliary driving voltage lines disposed in the display area and extending in the second direction, wherein the first driving voltage lines may be electrically connected to the first auxiliary driving voltage lines.

According to an embodiment, the first auxiliary driving voltage lines and the second auxiliary driving voltage lines may be disposed alternately in the first direction.

According to an embodiment, the first driving voltage lines and the second driving voltage lines may be disposed alternately in the second direction.

According to an embodiment, one of the first driving voltage lines, one of the first driving voltage lines, one of the second driving voltage lines, and one of the first driving voltage lines may be repeatedly disposed in the second direction.

According to an embodiment, a voltage level of a first driving voltage transmitted through the first driving voltage lines may be different from a voltage level of a second driving voltage transmitted through the second driving voltage lines.

According to an embodiment, the display apparatus may further include first voltage connection electrodes electrically connecting the second driving voltage supply line and the second driving voltage lines, wherein the first driving voltage supply line, the second driving voltage supply line, and the third driving voltage supply line may be sequentially disposed in the first direction in a plan view, and each of the first voltage connection electrodes may be electrically connected to a corresponding one of the second driving voltage lines (e.g., to a corresponding second driving voltage line of the second driving voltage lines) through a contact hole, and the contact hole may be defined between the second driving voltage supply line and the third driving voltage supply line.

According to an embodiment, the first driving voltage lines may be disposed on a different layer from the third driving voltage supply line and on a same layer as the fourth driving voltage supply line.

According to an embodiment, the second driving voltage lines may be disposed on a same layer as the second driving voltage supply line and on a different layer from the fifth driving voltage supply line.

According to an embodiment, a width of the first driving voltage supply line along the first direction may be different from a width of the second driving voltage supply line along the first direction.

According to an embodiment, a width of the fourth driving voltage line along the first direction may be different from a width of the fifth driving voltage supply line along the first direction.

According to an embodiment, the display apparatus may further include pads (e.g., of a corresponding pad unit) disposed in the first peripheral area, may further include first voltage connection lines electrically connecting the first driving voltage supply line and corresponding pads among the pads to each other, and may further include second voltage connection lines electrically connecting the second driving voltage supply line and corresponding pads among the pads to each other.

According to an embodiment, the first voltage connection lines may include a first sub-connection line, the second voltage connection lines may include a second sub-connection line adjacent to the first sub-connection line, and a width of the first sub-connection line and a width of the second sub-connection line may be different from each other.

According to an embodiment, the display apparatus may further include a first bottom driving voltage supply line disposed in the first peripheral area and extending in the second direction, may further include a second bottom driving voltage supply line disposed in the second peripheral area and extending in the second direction, may further include a third bottom driving voltage supply line disposed in the third peripheral area, extending in the first direction, and connected to the first bottom driving voltage supply line and the second bottom driving voltage supply line, and may further include a fourth bottom driving voltage supply line disposed in the fourth peripheral area, extending in the first direction, and connected to the first bottom driving voltage supply line and the second bottom driving voltage supply line.

According to an embodiment, the display apparatus may further include an auxiliary driving voltage supply line disposed between the second bottom driving voltage supply line and the display area and extending in the second direction.

According to an embodiment, the display apparatus may further include vertical voltage lines extending from the first bottom driving voltage supply line to the auxiliary driving voltage supply line, and may further include horizontal voltage lines extending from the third bottom driving voltage supply line to the fourth bottom driving voltage supply line and connected to the vertical voltage lines.

According to an embodiment, the third driving voltage supply line may be arranged on the first bottom driving voltage supply line and may overlap the first bottom driving voltage supply line in a plan view, and the fourth driving voltage supply line may be arranged on the second bottom driving voltage supply line and may overlap the second bottom driving voltage supply line in a plan view.

According to one or more embodiments, an electronic device includes a display apparatus which is configured to display an image, a memory which is configured to store an application, and a processor which is configured to execute the application and transmits an image data signal or a control signal to the display apparatus, wherein the display apparatus includes a substrate including a display area, a first peripheral area disposed on one side of the display area, a second peripheral area disposed on the other side of the display area, and a third peripheral area and a fourth peripheral area, wherein the third peripheral area and the fourth peripheral area connect the first peripheral area and the second peripheral area to each other, first driving voltage lines and second driving voltage lines, which are disposed in the display area and extend in a first direction, first pixel circuits and third pixel circuits, which are disposed in the display area and electrically connected to the first driving voltage lines, second pixel circuits disposed in the display area and electrically connected to the second driving voltage lines, a first driving voltage supply line, a second driving voltage supply line, and a third driving voltage supply line, which are disposed in the first peripheral area and extend in a second direction intersecting the first direction, and a fourth driving voltage supply line and a fifth driving voltage supply line disposed in the second peripheral area and extending in the second direction, wherein the first driving voltage supply line is electrically connected to the third driving voltage supply line, the first driving voltage lines are electrically connected to the third driving voltage supply line and the fourth driving voltage supply line, and the second driving voltage lines are electrically connected to the second driving voltage supply line and the fifth driving voltage supply line. In particular, the display apparatus of the electronic device may be a display apparatus according to one or more embodiments of the present disclosure.

According to an embodiment, a voltage level of a first driving voltage transmitted through the first driving voltage line may be different from a voltage level of a second driving voltage transmitted through the second driving voltage line.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

The above and other features of certain embodiments of the disclosure will be more apparent from the following description taken in conjunction with the accompanying drawings, in which:
FIG. 1 is a schematic plan view of a display apparatus according to an embodiment;
FIG. 2 is a schematic cross-sectional view of a display apparatus according to an embodiment;
FIG. 3 is a schematic plan view of a display apparatus according to an embodiment;
FIGS. 4A and 4B are schematic plan views, each illustrating driving voltage supply lines of a display apparatus according to an embodiment;
FIG. 5 is a schematic plan view of pixels of a display apparatus according to an embodiment;
FIG. 6A is a schematic diagram illustrating a light-emitting diode of a display apparatus according to an embodiment;
FIG. 6B is a schematic diagram illustrating another light-emitting diode of a display apparatus according to an embodiment;
FIG. 7A is an equivalent circuit diagram schematically illustrating a pixel circuit electrically connected to the light-emitting diode of FIG. 6A, and FIG. 7B is an equivalent circuit diagram schematically illustrating a pixel circuit electrically connected to the light-emitting diode of FIG. 6B;
FIG. 8 is a schematic plan view illustrating an area I of the display apparatus of FIG. 4B;
FIG. 9 is a schematic plan view illustrating an area II of the display apparatus of FIG. 4B;
FIG. 10 is a schematic cross-sectional view taken along line IV-IV' of the display apparatus of FIG. 9;
FIGS. 11A and 11B are schematic plan views, each illustrating an area V of the display apparatus of FIG. 9;
FIG. 12 is a schematic plan view of a portion of a display apparatus according to an embodiment;
FIGS. 13A and 13B are schematic plan views, each illustrating an area **III** of the display apparatus of FIG. 4B.
FIG. 14 is a schematic plan view of pixel circuits of a display apparatus according to an embodiment;
FIGS. 15A and 15B are schematic plan views, each illustrating a mesh structure of a display apparatus according to an embodiment.
FIGS. 16A and 16B are schematic plan views, each illustrating a mesh structure of a display apparatus according to an embodiment;
FIG. 17 is a schematic block diagram of an electronic device according to an embodiment; and
FIGS 18, 19, and 20 are schematic diagrams of electronic devices according to various embodiments.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements through.

Effects and features of the disclosure, and methods for achieving them will be clarified with reference to embodiments described below in detail with reference to the drawings.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

In the specification, it will be further understood that, when a layer, region, or component is referred to as being "on" another layer, region, or component, it may be directly on the other layer, region, or component, or may be indirectly on the other layer, region, or component with intervening layers, regions, or components therebetween. In contrast, when an element is referred to as being "directly on" another element, there are no intervening elements present.

In the specification, it will be understood that when a layer, a region, or a component is referred to as being "connected" to another layer, region, or component, it may be "directly connected" to the other layer, region, or component and/or may be "indirectly connected" to the other layer, region, or component with other layers, regions, or components therebetween. For example, when a layer, a region, or a component is referred to as being "electrically connected," it may be directly electrically connected, and/or may be indirectly electrically connected with intervening layers, regions, or components therebetween.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

In the specification, the x-direction, y-direction, and z-direction are not limited to directions along the three axes on the orthogonal coordinate system, and may be interpreted in a broad sense including these. For example, the x-direction, y-direction, and z-direction may be orthogonal to each other, but they may also refer to different directions that are not orthogonal to each other.

In the specification, when a component is seen in a "plan view," it means that the component is seen from above (e.g., the component is seen in a direction perpendicular to a top surface of a substrate), and when a component is seen in a "cross-sectional view," it means that the component is cut vertically and seen from the side.

In the specification, when a first component "overlaps" a second component, it means that the first component is located above or below the second component so that at least a portion of the first component overlaps the second component in a plan view.

In the specification, "ON" or "on" used in association with an element state may be referred to as an activated state of an element, and "OFF" or "off" may be referred to as an inactivated state of an element. "ON" or "on" used in association with a signal received by an element may be referred to as a signal for activating the element, and "OFF" or "off" may be referred to as a signal for inactivating the element. The element may be activated by a high-level voltage or a low-level voltage. For example, a P-channel transistor (P-type transistor) is activated by a low-level voltage, and an N-channel transistor (N-type transistor) is activated by a high-level voltage. Therefore, it is important to understand that the "on" voltages for P-type and N-type transistors are opposite (low vs. high) voltage levels.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Also, for convenience of explanation, components in the drawings may have exaggerated or reduced sizes. For example, the size and thickness of each component shown in the drawing are arbitrarily shown for convenience of explanation, and thus the disclosure is not necessarily limited to what is shown.

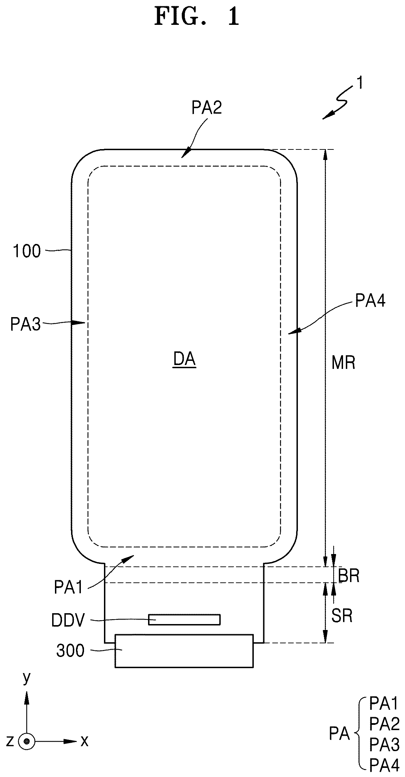

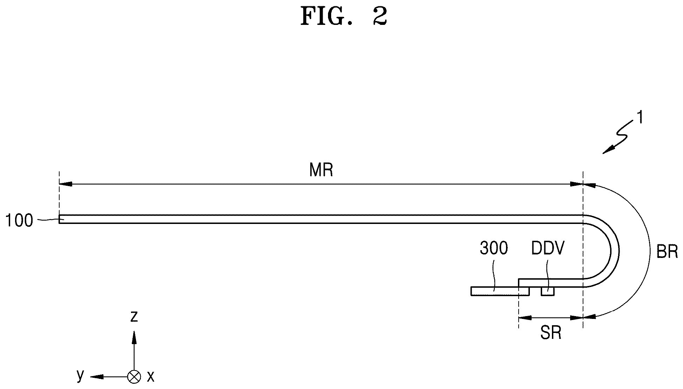

FIG. 1 is a schematic plan view of a display apparatus 1 according to an embodiment, and FIG. 2 is a schematic cross-sectional view of the display apparatus 1 according to an embodiment.

Referring to FIG. 1, an embodiment of the display apparatus 1 may include a display area DA and a peripheral area PA outside the display area DA. The display area DA may be a portion that displays an image, and multiple pixels may be disposed in the display area DA. The display area DA may have any one of various shapes, such as a circular shape, an elliptical shape, a polygonal shape, and a specific shape, for example. In FIG. 1, an embodiment where the display area DA has a generally rectangular shape with rounded corners is shown.

The peripheral area PA may be disposed outside the display area DA. The peripheral area PA may include a first peripheral area PA1 located below (e.g., -y side) the display area DA and extending in a first direction (e.g., x-axis direction), a second peripheral area PA2 located above (e.g., +y side) the display area DA and extending in the first direction (e.g., x-axis direction), a third peripheral area PA3 located on the left (e.g., -x side) of the display area DA and extending in a second direction (e.g., y-axis direction), and a fourth peripheral area PA4 located on the right (e.g., +x side) of the display area DA and extending in the second direction (e.g., y-axis direction). The first peripheral area PA1 and the second peripheral area PA2 may be opposite to each other with the display area DA therebetween, and the third peripheral area PA3 and the fourth peripheral area PA4 may connect the first peripheral area PA1 and the second peripheral area PA2 to each other outside the display area DA. A portion of the first peripheral area PA1 may extend in the second direction (e.g., y-axis direction) and have a width along the first direction (e.g., x-axis direction) narrower than a width of the display area DA. This structure may allow at least a portion of the first peripheral area PA1 to be easily bent.

An embodiment of the display apparatus 1, as illustrated in FIG. 1, may include a substrate 100. In an embodiment where the display apparatus 1 includes the display area DA and the peripheral area PA outside the display area DA, the substrate 100 may also include portions corresponding to the display area DA and the peripheral area PA outside the display area DA. In such an embodiment, the substrate 100 may be understood as including the display area DA and the peripheral area PA.

The display apparatus 1 may include a main region MR, a bending region BR outside the main region MR, and a sub-region SR spaced apart from the main region MR with the bending region BR therebetween. The main region MR may be disposed on one side of the bending region BR, and the sub-region SR may be disposed on the other side of the bending region BR.

The main region MR may overlap the display area DA, a portion of the first peripheral area PA1, the second peripheral area PA2, the third peripheral area PA3, and the fourth peripheral area PA4. The bending region BR and the sub-region SR may overlap a portion of the first peripheral area PA1 extending in the second direction (e.g., y-axis direction).

The display apparatus 1 may be bent in the bending region BR as illustrated in FIG. 2, and at least a portion of the sub-region SR may overlap the main region MR when viewed in the third direction (z-axis direction). FIG. 2 illustrates an embodiment where the display apparatus 1 is bent, but the disclosure is not limited thereto. In an embodiment, for example, the display apparatus 1 may be a foldable display apparatus. In such an embodiment, the display apparatus 1 may be bent within the display area DA about a bending axis crossing the display area DA. If desired, the display apparatus 1 may not be bent.

A data driver DDV may be disposed in the sub-region SR of the display apparatus 1. The data driver DDV may be disposed in the display apparatus 1 in the form of an integrated circuit (IC). In an embodiment, for example, the data driver DDV may be a data driving integrated circuit that generates data voltages.

A display circuit board 300 may be attached to an end of the sub-region SR of the display apparatus 1. The display circuit board 300 may be electrically connected to the data driver DDV or the like through pads located in the sub-region SR of the display apparatus 1.

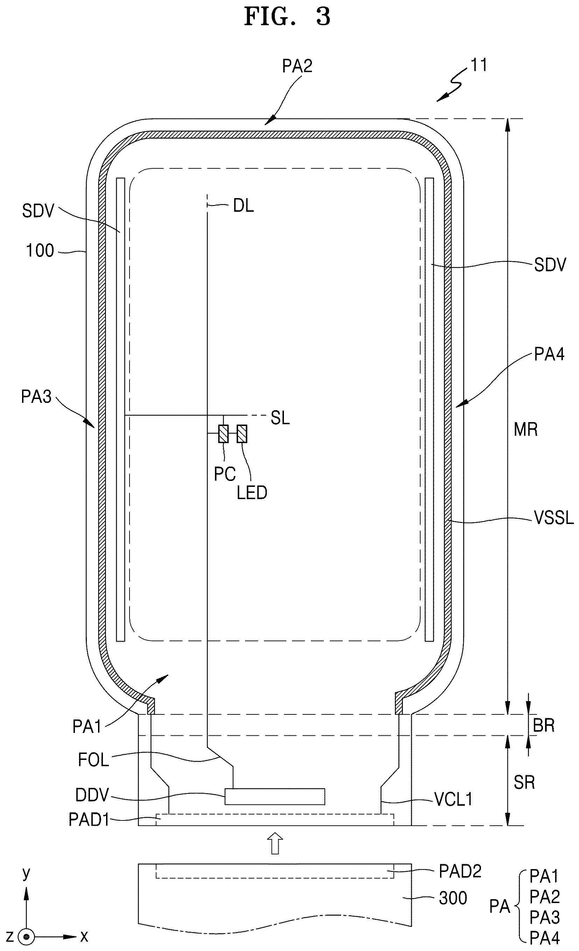

FIG. 3 is a schematic plan view of the display apparatus 1 according to an embodiment.

Referring to FIG. 3, an embodiment of the display apparatus 1 may include the substrate 100. Various components forming the display panel may be disposed on the substrate 100.

The substrate 100 may include glass, ceramic, metal, or polymer resin. The substrate 100 may include a polymer resin such as polyethersulfone, polyacrylate, polyetherimide, polyethylene naphthalate, polyethylene terephthalate, polyphenylene sulfide, polyarylate, polyimide, polycarbonate, or cellulose acetate propionate. The substrate 100 may have a multi-layered structure including two layers containing the above-described polymer resin and an inorganic layer disposed between the two layers. Alternatively, the substrate 100 may have a structure in which layers containing the above-described polymer resin and inorganic layers are alternately stacked. The inorganic layer may include, for example, silicon oxide, silicon nitride or silicon oxynitride.

Pixels may be disposed in the display area DA, and the display area DA may provide images by using light emitted from the pixels. Each pixel may include a light-emitting diode LED, which may be electrically connected to a pixel circuit PC. The pixel circuit PC and the light-emitting diode LED may be disposed in the display area DA. In FIG. 3, an embodiment where the pixel circuit PC and the light-emitting diode LED are disposed side by side is shown. In some embodiments, the pixel circuit PC and the light-emitting diode LED may at least partially overlap in a plan view. In an embodiment, for example, the light-emitting diode LED may be disposed on the pixel circuit PC.

A gate driver SDV, a pad unit PAD1, and voltage supply lines may be disposed in the peripheral area PA. For convenience of illustration, FIG. 3 shows only a common voltage supply line VSSL among the voltage supply lines.

The gate driver SDV may provide scan signals to the pixel circuit PC through a gate line SL. In an embodiment, a plurality of gate drivers SDV may be provided. In an embodiment, for example, the gate drivers SDV may face each other, in the third peripheral area PA3 and the fourth peripheral area PA4, with the display area DA therebetween. Some of pixel circuits PC disposed in the display area DA may be electrically connected to the gate driver SDV disposed in the third peripheral area PA3, and the remaining pixel circuits PC may be electrically connected to the gate driver SDV disposed in the fourth peripheral area PA4. In an embodiment, the gate driver SDV may be provided only in the third peripheral area PA3 or the fourth peripheral area PA4.

The pad unit (or pad area) PAD1 may be disposed (or defined) at the end of the sub-region SR. The pad unit PAD1 may include a plurality of pads that are exposed and not covered by an insulating layer. The pad unit PAD1 may be electrically connected to the display circuit board 300. A pad unit PAD2 of the display circuit board 300 may be electrically connected to the pad unit PAD1 of the substrate 100.

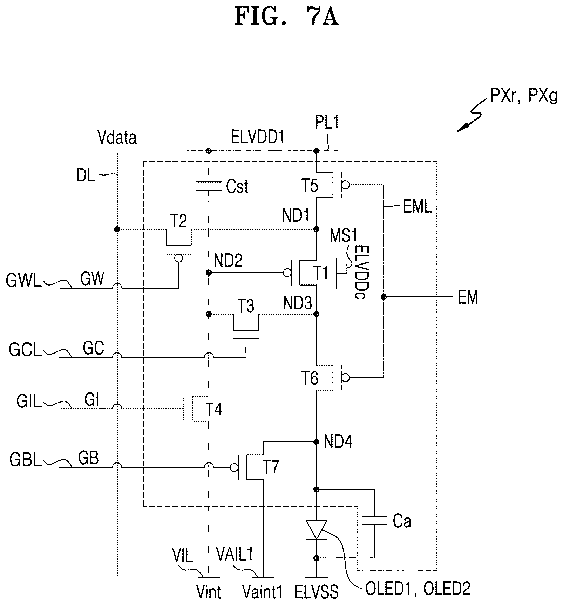

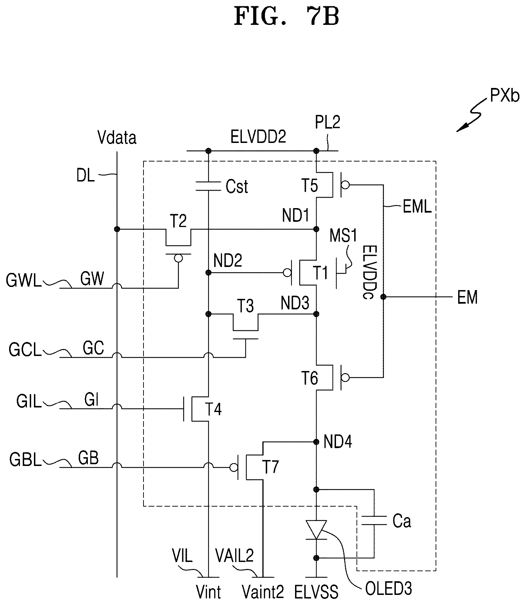

The display circuit board 300 transmits signals or power from a control unit to the data driver DDV, the gate driver SDV, and the voltage supply lines. Control signals generated in the control unit may be transmitted to the gate driver SDV and the data driver DDV, respectively, through the display circuit board 300. Additionally, the control unit may provide driving voltages ELVDD1, ELVDD2, ELVDDc (refer to FIGS. 7A and 7B), a common voltage ELVSS (refer to FIGS. 7A and 7B), etc., to the voltage supply lines. The common voltage ELVSS may be provided to a common electrode of the light-emitting diode LED electrically connected to the common voltage supply line VSSL.

The common voltage supply line VSSL may have a loop shape with one side open, and may at least partially surround the display area DA. Opposite ends of the common voltage supply line VSSL may be electrically connected to corresponding pads of the pad unit PAD1 via first voltage connection lines VCL1.

The data driver DDV outputs data voltage Vdata (see FIGS. 7A and 7B), and the data voltage Vdata may be transmitted to the pixel circuit PC through a fan-out line FOL and a data line DL electrically connected to the fan-out line FOL.

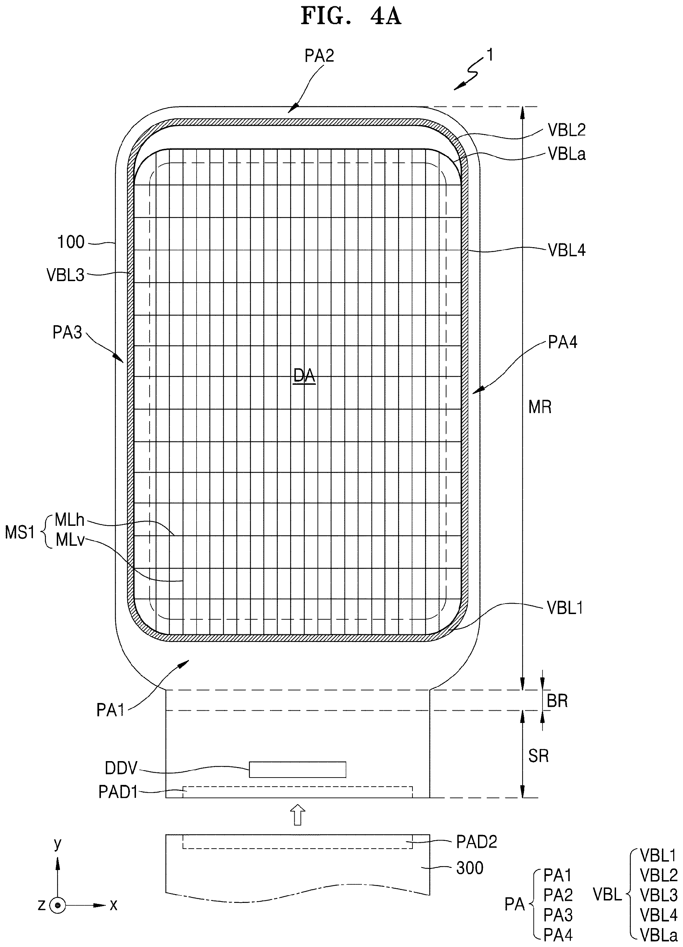

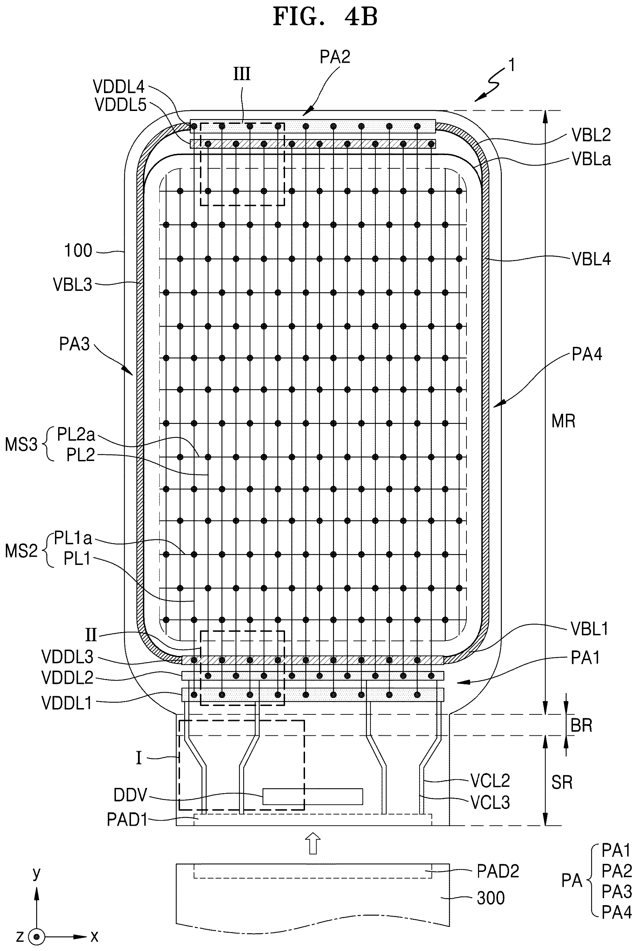

FIGS. 4A and 4B are schematic plan views, each illustrating driving voltage supply lines of the display apparatus 1 according to an embodiment.

For convenience of illustration, FIG. 4A schematically illustrates lines that transmit a common driving voltage ELVDDc (see FIGS. 7A and 7B). FIG. 4B schematically illustrates lines that transmit a first driving voltage ELVDD1 (see FIG. 7A) and lines that transmit a second driving voltage ELVDD2 (see FIG. 7B).

Referring to FIG. 4A, an embodiment of the display apparatus 1 may include the substrate 100, and a bottom driving voltage supply line VBL may be disposed in the peripheral area PA of the substrate 100.

The bottom driving voltage supply line VBL may have a closed curve shape that completely surrounds the display area DA and is disposed outside the display area DA in a plan view (or when viewed in z-axis direction). In an embodiment, for example, the bottom driving voltage supply line VBL may include a first bottom driving voltage supply line VBL1 extending along the first direction (e.g., x-axis direction) in the first peripheral area PA1, a second bottom driving voltage supply line VBL2 extending along the first direction (e.g., x-axis direction) in the second peripheral area PA2, a third bottom driving voltage supply line VBL3 extending along the second direction (e.g., y-axis direction) in the third peripheral area PA3, and a fourth bottom driving voltage supply line VBL4 extending along the second direction (e.g., y-axis direction) in the fourth peripheral area PA4. An auxiliary driving voltage supply line VBLa extending along the first direction (e.g., x-axis direction) may be further disposed between the second bottom driving voltage supply line VBL2 and the display area DA. In the second peripheral area PA2, the bottom driving voltage supply line VBL may branch into the second bottom driving voltage supply line VBL2 and the auxiliary driving voltage supply line VBLa.

A plurality of horizontal mesh wires MLh and a plurality of vertical mesh wires MLv may be disposed in the display area DA. The horizontal mesh wires MLh may extend in the first direction (e.g., x-axis direction) and may be disposed to be spaced apart from each other in the second direction (e.g., y-axis direction). The vertical mesh wires MLv may extend in the second direction (e.g., y-axis direction) and may be disposed to be spaced apart from each other in the first direction (e.g., x-axis direction).

Each of the vertical mesh wires MLv may extend from the first bottom driving voltage supply line VBL1 to the auxiliary driving voltage supply line VBLa and may be electrically connected to the first bottom driving voltage supply line VBL1 and the auxiliary driving voltage supply line VBLa. Each of the horizontal mesh wires MLh may extend from the third bottom driving voltage supply line VBL3 to the fourth bottom driving voltage supply line VBL4 and may be electrically connected to the third bottom driving voltage supply line VBL3 and the fourth bottom driving voltage supply line VBL4.

The horizontal mesh wires MLh and the vertical mesh wires MLv may intersect with each other in the display area DA and may be electrically connected to each other to form a first mesh structure MS1. The first mesh structure MS1 may overlap the display area DA and be electrically connected to the bottom driving voltage supply line VBL. In an embodiment, the bottom driving voltage supply line VBL and the first mesh structure MS1 may be integrally provided or integrally formed with each other as a single unitary indivisible part. Herein, the bottom driving voltage supply line VBL being integrated with the first mesh structure MS1 means that the bottom driving voltage supply line VBL and the first mesh structure MS1 may be provided in (or directly on) a same layer as each other and directly connected to each other. The bottom driving voltage supply line VBL and the first mesh structure MS1 may be included in (or defined by portions of) a first conductive layer.

Referring to FIG. 4B, a first driving voltage supply line VDDL1, a second driving voltage supply line VDDL2, and a third driving voltage supply line VDDL3 may be disposed in the first peripheral area PA1 of the substrate 100, and a fourth driving voltage supply line VDDL4 and a fifth driving voltage supply line VDDL5 may be disposed in the second peripheral area PA2 of the substrate 100. In FIG. 4B, the bottom driving voltage supply line VBL is illustrated, but for convenience of illustration, the first mesh structure MS1 is not illustrated.

The first driving voltage supply line VDDL1 may extend in the first direction (e.g., x-axis direction) in the first peripheral area PA1. The first driving voltage supply line VDDL1 may be electrically connected to the pad unit PAD1 via second voltage connection lines VCL2. The control unit may provide the first driving voltage ELVDD1 (see FIG. 7A) to the first driving voltage supply line VDDL1 through the display circuit board 300.

The second driving voltage supply line VDDL2 may extend in the first direction (e.g., x-axis direction) in the first peripheral area PA1. The second driving voltage supply line VDDL2 may be disposed between the first driving voltage supply line VDDL1 and the third driving voltage supply line VDDL3 in a plan view. The second driving voltage supply line VDDL2 may be electrically connected to the pad unit PAD1 via third voltage connection lines VCL3. The control unit may provide the second driving voltage ELVDD2 (see FIG. 7B) to the second driving voltage supply line VDDL2 through the display circuit board 300.

Voltage levels of the first driving voltage ELVDD1 and the second driving voltage ELVDD2 may be different from each other. In an embodiment, the voltage level of the first driving voltage ELVDD1 may be lower than the voltage level of the second driving voltage ELVDD2. In an embodiment, for example, the common voltage ELVSS (see FIGS. 7A and 7B) may be about -6 volts (V), the first driving voltage ELVDD1 may be about 5 V, and the second driving voltage ELVDD2 may be about 7 V.

The third driving voltage supply line VDDL3 may extend in the first direction (e.g., x-axis direction) in the first peripheral area PA1 and may overlap the first bottom driving voltage supply line VBL1 in a plan view (e.g., when viewed from a direction approximately perpendicular to the substrate 100 or in z-axis direction). The third driving voltage supply line VDDL3 may be disposed on the first bottom driving voltage supply line VBL1. The third driving voltage supply line VDDL3 may be electrically connected to the first driving voltage supply line VDDL1 and the first bottom driving voltage supply line VBL1. When a voltage applied to the bottom driving voltage supply line VBL is referred to as the common driving voltage ELVDDc (see FIGS. 7A and 7B), the common driving voltage ELVDDc may be the first driving voltage ELVDD1. However, the disclosure is not limited thereto, and the common driving voltage ELVDDc may be the second driving voltage ELVDD2.

The fourth driving voltage supply line VDDL4 may extend in the first direction (e.g., x-axis direction) in the second peripheral area PA2. The fourth driving voltage supply line VDDL4 may overlap the second bottom driving voltage supply line VBL2 in a plan view. The fourth driving voltage supply line VDDL4 may be disposed on the second bottom driving voltage supply line VBL2. The fourth driving voltage supply line VDDL4 may be electrically connected to the second bottom driving voltage supply line VBL2 and may receive the first driving voltage ELVDD1.

The fifth driving voltage supply line VDDL5 may extend in the first direction (e.g., x-axis direction) in the second peripheral area PA2. The fifth driving voltage supply line VDDL5 may be disposed between the fourth driving voltage supply line VDDL4 and the auxiliary driving voltage supply line VBLa in a plan view.

A plurality of first driving voltage lines PL1, a plurality of first auxiliary driving voltage lines PL1a, a plurality of second driving voltage lines PL2, and a plurality of second auxiliary driving voltage lines PL2a may be disposed in the display area DA. The first driving voltage lines PL1 and the second driving voltage lines PL2 may extend approximately (or substantially) in the second direction (e.g., y-axis direction) and be spaced apart from each other in the first direction (e.g., x-axis direction). The first driving voltage lines PL1 and the second driving voltage lines PL2 may be disposed in the first direction (e.g., x-axis direction) according to a predefined rule or in a predetermined arrangement pattern. The first auxiliary driving voltage lines PL1a and the second auxiliary driving voltage lines PL2a may extend in the first direction (e.g., x-axis direction) and may be spaced apart from each other in the second direction (e.g., y-axis direction). In another embodiment, the first auxiliary driving voltage lines PL1a may be omitted.

The first driving voltage lines PL1 may extend from the third driving voltage supply line VDDL3 to the fourth driving voltage supply line VDDL4 and may be electrically connected to the third driving voltage supply line VDDL3 and the fourth driving voltage supply line VDDL4. The fourth driving voltage supply line VDDL4 may receive the first driving voltage ELVDD1 (refer to FIG. 7A) from the third driving voltage supply line VDDL3 through the first driving voltage lines PL1.

The first driving voltage lines PL1 and the first auxiliary driving voltage lines PL1a may intersect each other in the display area DA and may be electrically connected to each other through contact holes disposed in the display area DA to form a second mesh structure MS2. The second mesh structure MS2 may overlap the display area DA and receive the first driving voltage ELVDD1. Accordingly, a voltage drop (e.g., IR drop) of the first driving voltage ELVDD1 in the display area DA may be effectively prevented or substantially minimized.

The second driving voltage lines PL2 may extend from the second driving voltage supply line VDDL2 to the fifth driving voltage supply line VDDL5 and may be electrically connected to the second driving voltage supply line VDDL2 and the fifth driving voltage supply line VDDL5. The fifth driving voltage supply line VDDL5 may receive the second driving voltage ELVDD2 (see FIG. 7B) from the second driving voltage supply line VDDL2 through the second driving voltage lines PL2.

The second driving voltage lines PL2 and the second auxiliary driving voltage lines PL2a may intersect each other in the display area DA and may be electrically connected to each other through contact holes disposed in the display area DA to form a third mesh structure MS3. The third mesh structure MS3 may overlap the display area DA and receive the second driving voltage ELVDD2. Accordingly, a voltage drop of the second driving voltage ELVDD2 in the display area DA may be effectively prevented or substantially minimized.

The first driving voltage lines PL1 may be electrically connected to some pixel circuits among a plurality of pixel circuits PC disposed in the display area DA to provide the first driving voltage ELVDD1. The second driving voltage lines PL2 may be electrically connected to the remaining pixel circuits among the plurality of pixel circuits PC disposed in the display area DA to provide the second driving voltage ELVDD2.

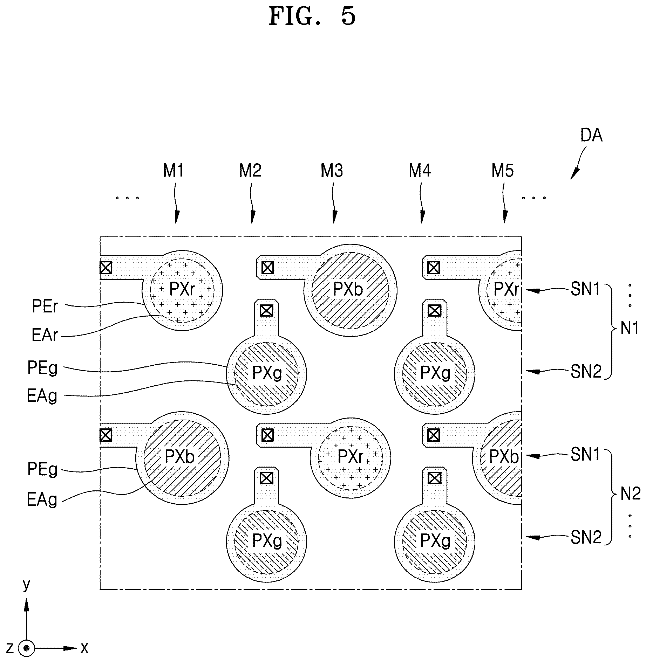

FIG. 5 is a schematic plan view of pixels of a display apparatus 1 according to an embodiment.

Referring to FIG. 5, in an embodiment, a plurality of pixels may be disposed in the display area DA of the display apparatus 1. The pixels may include first pixels PXr, second pixels PXg, and third pixels PXb. The first pixels PXr, the second pixels PXg, and the third pixels PXb may be repeatedly disposed in the first direction (e.g., x-axis direction) and the second direction (e.g., y-axis direction) according to a predefined rule or in a predetermined arrangement pattern. The first pixels PXr, the second pixels PXg, and the third pixels PXb may each include a pixel circuit and a light-emitting diode electrically connected to the pixel circuit. The light-emitting diode of each pixel may be disposed on the pixel circuit. In an embodiment, for example, the light-emitting diode may be disposed directly above a corresponding pixel circuit to overlap the corresponding pixel circuit, or may be disposed to be offset from the corresponding pixel circuit and to partially overlap the pixel circuit of another pixel disposed in an adjacent row and/or column.

FIG. 5 shows pixel electrodes and emission areas of the light-emitting diodes of each of the first pixels PXr, the second pixels PXg, and the third pixels PXb. The emission area may be defined by a pixel-defining layer having an opening defined therethrough corresponding to a center of the pixel electrode. In an embodiment, for example, the light-emitting diode of the first pixel PXr may include a first pixel electrode PEr, and a first emission area EAr may be defined in a central portion of the first pixel electrode PEr exposed by an opening of the pixel-defining layer. The light-emitting diode of the second pixel PXg may include a second pixel electrode PEg, and a second emission area EAg may be defined in a central portion of the second pixel electrode PEg exposed by an opening of the pixel-defining layer. The light-emitting diode of the third pixel PXb may include a third pixel electrode PEb, and a third emission area EAb may be defined in a central portion of the third pixel electrode PEb exposed by an opening of the pixel-defining layer.

In a first column M1, the first emission area EAr of the first pixel PXr and the third emission area EAb of the third pixel PXb may be arranged alternately in the second direction (e.g., y-axis direction). In a second column M2, the second emission area EAg of the second pixel PXg may be repeatedly arranged in the second direction (e.g., y-axis direction). In a third column M3, the third emission area EAb of the third pixel PXb and the first emission area EAr of the first pixel PXr may be arranged alternately in the second direction (e.g., y-axis direction). In a fourth column M4, the second emission area EAg of the second pixel PXg may be repeatedly arranged in the second direction (e.g., y-axis direction). The pixels may be repeatedly arranged in units of four columns. In an embodiment, for example, in a fifth column M5, the first emission area EAr of the first pixel PXr and the third emission area EAb of the third pixel PXb may be arranged alternately in the second direction (e.g., y-axis direction), similarly to the first column M1.

Each row may include a first sub-row SN1 and a second sub-row SN2. In the first sub-row SN1 of a first row N1, the first emission area EAr of the first pixel PXr and the third emission area EAb of the third pixel PXb may be arranged alternately in the first direction (e.g., x-axis direction). In the first sub-row SN1 of a second row N2, the third emission area EAb of the third pixel PXb and the first emission area EAr of the first pixel PXr may be arranged alternately in the first direction (e.g., x-axis direction). In the second sub-row SN2 of each row, the second emission area EAg of the second pixel PXg may be repeatedly arranged in the first direction (e.g., x-axis direction).

That is, in the first row N1, the first emission area EAr of the first pixel PXr, the second emission area EAg of the second pixel PXg, the third emission area EAb of the third pixel PXb, and the second emission area EAg of the second pixel PXg may be repeatedly arranged in a staggered form. In the second row N2, the third emission area EAb of the third pixel PXb, the second emission area EAg of the second pixel PXg, the first emission area EAr of the first pixel PXr, and the second emission area EAg of the second pixel PXg may be repeatedly arranged in a staggered form. The pixels may be repeatedly arranged in units of two rows.

The first emission area EAr, the second emission area EAg, and the third emission area EAb may have a polygonal shape such as a square, or a circular shape or an elliptical shape. An area of the first emission area EAr of the first pixel PXr, an area of the second emission area EAg of the second pixel PXg, and an area of the third emission area EAb of the third pixel PXb may be different from one another. In an embodiment, for example, the third emission area EAb may have a greater area than the first emission area EAr and the second emission area EAg. The first emission area EAr may have an area equal to or greater than an area of the second emission area EAg.

In an embodiment, the first pixel PXr may be a red subpixel that emits red light, the second pixel PXg may be a green subpixel that emits green light, and the third pixel PXb may be a blue subpixel that emits blue light.

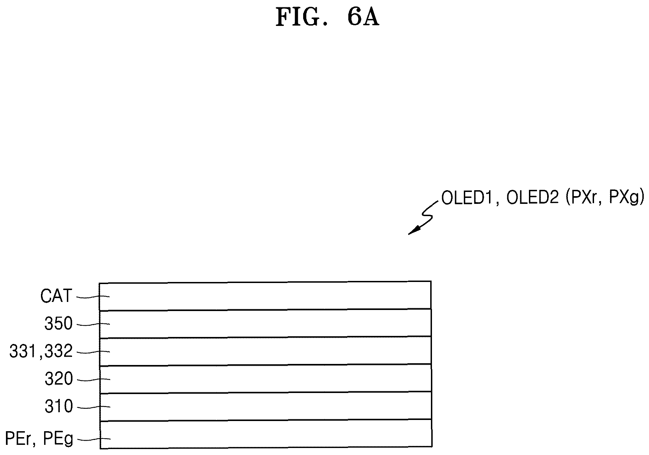

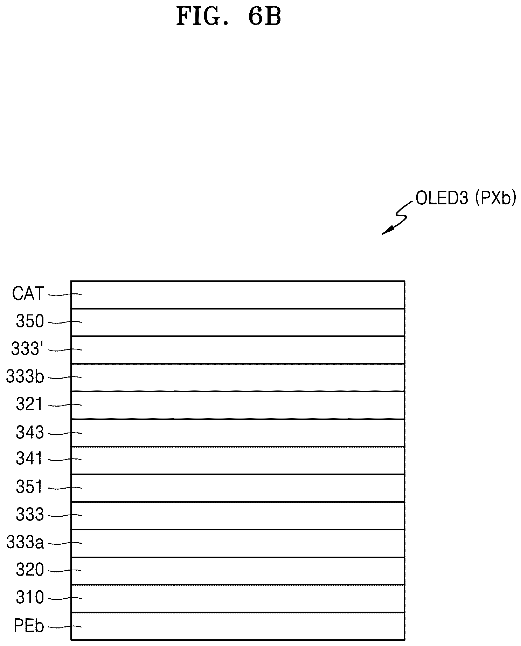

FIG. 6A is a schematic diagram illustrating a light-emitting diode of a display apparatus 1 according to an embodiment, and FIG. 6B is a schematic diagram illustrating another light-emitting diode of a display apparatus 1 according to an embodiment.

Specifically, FIG. 6A is a schematic diagram illustrating the configuration of a first organic light-emitting diode OLED1 included in the first pixel PXr or a second organic light-emitting diode OLED2 included in the second pixel PXg illustrated in FIG. 5. The first organic light-emitting diode OLED1 may be a light-emitting diode that emits red light, and the second organic light-emitting diode OLED2 may be a light-emitting diode that emits green light. FIG. 6B is a schematic diagram illustrating the configuration of a third organic light-emitting diode OLED3 included in the third pixel PXb illustrated in FIG. 5. The third organic light-emitting diode OLED3 may be a light-emitting diode that emits blue light.

Referring to FIG. 6A, in an embodiment, the first organic light-emitting diode OLED1 may have a multi-layered structure, including a first emission layer 331 between a first pixel electrode PEr and a common electrode CAT, and the second organic light-emitting diode OLED2 may have a multi-layered structure, including a second emission layer 332 between a second pixel electrode PEg and the common electrode CAT.

A hole injection layer 310 and a hole transport layer 320 may be disposed on the first pixel electrode PEr and the second pixel electrode PEg. On the hole transport layer 320, the first emission layer 331 may be arranged in correspondence with (or to overlap) the first pixel electrode PEr, and the second emission layer 332 may be arranged in correspondence with the second pixel electrode PEg. The first emission layer 331 may be a red emission layer, and the second emission layer 332 may be a green emission layer.

A first auxiliary hole transport layer may optionally be disposed between the first emission layer 331 and the hole transport layer 320. The first auxiliary hole transport layer may have a predefined thickness according to a resonance period of light emitted from the first emission layer 331, and may improve the color purity of light emitted from the first emission layer 331 or improve the luminous efficiency of the first pixel PXr. A second auxiliary hole transport layer may be disposed between the second emission layer 332 and the hole transport layer 320, optionally. The second auxiliary hole transport layer may have a predefined thickness according to a resonance period of light emitted from the second emission layer 332.

An electron transport layer 350 may be disposed on the first emission layer 331 and the second emission layer 332. A buffer layer may be disposed between the first emission layer 331 and the electron transport layer 350 and/or between the second emission layer 332 and the electron transport layer 350 as desired. The common electrode CAT may be disposed on the electron transport layer 350.

Referring to FIG. 6B, in an embodiment, the third organic light-emitting diode OLED3 may have a multi-layered structure including a plurality of third emission layers 333 and 333' between the third pixel electrode PEb and the common electrode CAT.

The hole injection layer 310 and the hole transport layer 320 may be disposed on the third pixel electrode PEb. A first third emission layer 333 may be disposed on the hole transport layer 320 in correspondence with the third pixel electrode PEb. The first third emission layer 333 may be a blue emission layer. A first blue auxiliary layer 333a may be disposed between the hole transport layer 320 and the third emission layer 333. The first blue auxiliary layer 333a may improve a light generation efficiency of the first third emission layer 333 by controlling the hole charge balance.

An electron transport layer 351, an electron generation layer 341, a hole generation layer 343, and a hole transport layer 321 may be sequentially arranged on the third emission layer 333. A second third emission layer 333' may be disposed on the hole transport layer 321 in correspondence with the third pixel electrode PEb. The second third emission layer 333' may be a blue emission layer. A second blue auxiliary layer 333b may be disposed between the second third emission layer 333' and the hole transport layer 321. The description provided for the first blue auxiliary layer 333a may be applied to the second blue auxiliary layer 333b. The electron generation layer 341 and the hole generation layer 343 may be referred to as a charge generation layer. In an embodiment, the electron generation layer 341 and the hole generation layer 343 may be integrally formed with each other as a single unitary indivisible part.

The electron transport layer 350 may be disposed on the second third emission layer 333'. A buffer layer may be disposed between the second third emission layer 333' and the electron transport layer 350 as needed. The common electrode CAT may be disposed on the electron transport layer 350. A portion corresponding to the first pixel electrode PEr, a portion corresponding to the second pixel electrode PEg, and a portion corresponding to the third pixel electrode PEb may be integrally formed with each other as a single unitary indivisible part, in the hole injection layer 310, the hole transport layer 320, the electron transport layer 350, and/or the common electrode CAT.

In the display apparatus 1 according to an embodiment, the third organic light-emitting diode OLED3 emitting blue light may have the plurality of third emission layers 333 and 333'. Compared with an emission layer that emits red light and an emission layer that emits green light, an emission layer that emits blue light may consume more current, have lower brightness, and have a shorter lifespan. In an embodiment, the third organic light-emitting diode OLED3 may include the plurality of emission layers 333 and 333', and the electron generation layer 341, the hole generation layer 343, and the like are disposed between the emission layers 333 and 333', such that the aforementioned problem may be solved.

In an embodiment, the first organic light-emitting diode OLED1 included in the first pixel PXr includes the first emission layer 331, the second organic light-emitting diode OLED2 included in the second pixel PXg includes the second emission layer 332, while the third organic light-emitting diode OLED3 included in the third pixel PXb further includes the plurality of emission layers 333, 333', the electron generation layer 341, the hole generation layer 343, etc. Therefore, it may be desired to control the voltage difference between the third pixel electrode PEb and the common electrode CAT of the third organic light-emitting diode OLED3 differently from the voltage difference between the first pixel electrode PEr and the common electrode CAT of the first organic light-emitting diode OLED1, and/or the voltage difference between the second pixel electrode PEg and the common electrode CAT of the second organic light-emitting diode OLED2. This will be described in greater detail below.

FIG. 7A is an equivalent circuit diagram schematically illustrating a pixel circuit electrically connected to the light-emitting diode of FIG. 6A, and FIG. 7B is an equivalent circuit diagram schematically illustrating a pixel circuit electrically connected to the light-emitting diode of FIG. 6B.

Referring to FIG. 7A, in an embodiment, the first pixel PXr may include a first pixel circuit PCr and the first organic light-emitting diode OLED1, and the second pixel PXg may include a second pixel circuit PCg and the second organic light-emitting diode OLED2. Each of the first pixel circuit PCr and the second pixel circuit PCg may include first to seventh transistors T1 to T7, a storage capacitor Cst, and an auxiliary capacitor Ca. The first pixel circuit PCr may be a pixel circuit electrically connected to the first organic light-emitting diode OLED1, and the second pixel circuit PCg may be a pixel circuit electrically connected to the second organic light-emitting diode OLED2. The first to seventh transistors T1 to T7 and the storage capacitor Cst may be electrically connected to the signal lines (e.g., a first scan line GWL, a second scan line GCL, a third scan line GIL, a fourth scan line GBL, an emission control line EML, and a data line DL), a first initialization voltage line VIL, a second initialization voltage line VAIL1, the first driving voltage line PL1, and the first mesh structure MS1.

Some transistors of the first to seventh transistors T1 to T7 may be n-channel metal oxide semiconductor field-effect transistors (MOSFETs) (hereinafter, will be referred to as "NMOS") and the remaining transistors may be p-channel MOSFETs (hereinafter, will be referred to as "PMOS"). In an embodiment, for example, among the first to seventh transistors T1 to T7, the third transistor T3 and the fourth transistor T4 may be NMOS, and the remaining transistors, the first transistor T1, the second transistor T2, the fifth transistor T5, the sixth transistor T6, and the seventh transistor T7 may be PMOS. In an embodiment, all of the first to seventh transistors T1 to T7 may be NMOS or all of the first to seventh transistors T1 to T7 may be PMOS.

In an embodiment, at least some (e.g., at least one) of the first to seventh transistors T1 to T7 may include amorphous silicon or polysilicon. The remaining transistors of the first to seventh transistors T1 to T7 may include oxide semiconductors. Because polysilicon has high reliability, it is possible to precisely control an intended current to flow. Accordingly, the first transistor T1, which directly affects the luminance of the display apparatus 1, may include a semiconductor layer including polysilicon having high reliability, and thus, a high-resolution display apparatus may be implemented. Since oxide semiconductors have high carrier mobility and low leakage current, a voltage drop is not large even if the driving time is long. Specifically, for oxide semiconductors, low-frequency driving is possible because the color shift of an image caused by the voltage drop is not substantial even during low-frequency operation.

Hereinafter, embodiments in which the third transistor T3 and the fourth transistor T4 are NMOS transistors including an oxide semiconductor, and the first transistor T1, the second transistor T2, the fifth transistor T5, the sixth transistor T6, and the seventh transistor T7 are PMOS transistors including polysilicon will be described as an example.

The signal lines may include the first scan line GWL configured to transmit a first scan signal GW, the second scan line GCL configured to transmit a second scan signal GC, the third scan line GIL configured to transmit a third scan signal GI, the fourth scan line GBL configured to transmit a fourth scan signal GB, the emission control line EML configured to transmit an emission control signal (or, a fifth scan signal, EM), and the data line DL configured to transmit the data voltage Vdata.

The first driving voltage line PL1 may transmit the first driving voltage ELVDD1 to the first transistor T1 of each of the first pixel circuit PCr and the second pixel circuit PCg. The first initialization voltage line VIL may be configured to transmit a first initialization voltage Vint that initializes a gate of the first transistor T1, and the second initialization voltage line VAIL1 may be configured to transmit a second initialization voltage Vaint1 that initializes each of the first pixel electrode PEr of the first organic light-emitting diode OLED1 and the second pixel electrode PEg of the second organic light-emitting diode OLED2.

The first pixel circuit PCr and the second pixel circuit PCg may have substantially the same or similar configurations as each other. Hereinafter, the first pixel PXr including the first pixel circuit PCr and the first organic light-emitting diode OLED1 will be mainly described.

Each of the first to seventh transistors T1 to T7 may include a gate (e.g., gate electrode), a first terminal (e.g., first electrode), and a second terminal (e.g., second electrode). The first terminal may be a source or a drain, and the second terminal may be a terminal of a different type from the first terminal. In an embodiment, for example, where the first terminal is a source (e.g., source electrode), the second terminal may be a drain (e.g., drain electrode).

The first transistor T1 may be a driving transistor. A gate of the first transistor T1 may be electrically connected to the storage capacitor Cst through a second node ND2. The first terminal of the first transistor T1 may be electrically connected to a first node ND1. The first transistor T1 may be electrically connected to the first driving voltage line PL1 via the fifth transistor T5. The second terminal of the first transistor T1 may be electrically connected to a third node ND3. The first transistor T1 may be electrically connected to the first organic light-emitting diode OLED1 via the sixth transistor T6. The first transistor T1 may receive the data voltage Vdata based on the switching operation of the second transistor T2 and supply a driving current to the first organic light-emitting diode OLED1.

The second transistor T2 may be a data writing transistor. A gate of the second transistor T2 may be electrically connected to the first scan line GWL, a first terminal of the second transistor T2 may be electrically connected to the data line DL, and a second terminal of the second transistor T2 may be electrically connected to the first node ND1. The second transistor T2 may be turned on in response to the first scan signal GW applied to the first scan line GWL and may transmit the data voltage Vdata from the data line DL to the first terminal of the first transistor T1 through the first node ND1.

The third transistor T3 may be a compensation transistor. A gate of the third transistor T3 may be electrically connected to the second scan line GCL, a first terminal of the third transistor T3 may be electrically connected to the second node ND2, and a second terminal of the third transistor T3 may be electrically connected to the third node ND3. The third transistor T3 may be turned on in response to the second scan signal GC received through the second scan line GCL to diode-connect the first transistor T1.

The fourth transistor T4 may be a first initialization transistor. A gate of the fourth transistor T4 may be electrically connected to the third scan line GIL, a first terminal of the fourth transistor T4 may be electrically connected to the second node ND2, and a second terminal of the fourth transistor T4 may be electrically connected to the first initialization voltage line VIL. The fourth transistor T4 may be turned on in response to the third scan signal GI received through the third scan line GIL to transmit the first initialization voltage Vint to the gate electrode of the first transistor T1, thereby initializing the voltage of the gate electrode of the first transistor T1.

The fifth transistor T5 may be an operation control transistor. A gate of the fifth transistor T5 may be electrically connected to the emission control line EML, a first terminal of the fifth transistor T5 may be electrically connected to a first driving voltage line PL1, and a second terminal of the fifth transistor T5 may be electrically connected to the first node ND1.

The sixth transistor T6 may be an emission control transistor. A gate of the sixth transistor T6 may be electrically connected to the emission control line EML, a first terminal of the sixth transistor T6 may be electrically connected to the third node ND3, and a second terminal of the sixth transistor T6 may be electrically connected to a fourth node ND4. The second terminal of the sixth transistor T6 may be electrically connected to the first organic light-emitting diode OLED1 through the fourth node ND4.

The fifth transistor T5 and the sixth transistor T6 may be turned on simultaneously in response to the emission control signal EM received through the emission control line EML, thereby allowing driving current to flow from the first transistor T1 to the first organic light-emitting diode OLED1.

The seventh transistor T7 may be a second initialization transistor. A gate of the seventh transistor T7 may be electrically connected to the fourth scan line GBL, a first terminal of the seventh transistor T7 may be electrically connected to the fourth node ND4, and a second terminal of the seventh transistor T7 may be electrically connected to the second initialization voltage line VAIL1. The seventh transistor T7 may be turned on in response to the fourth scan signal GB received through the fourth scan line GBL, and may initialize the first pixel electrode PEr of the first organic light-emitting diode OLED1 with the second initialization voltage Vaint1. In an embodiment, the fourth scan signal GB may be the first scan signal GW of the previous row.

The storage capacitor Cst may include a first capacitor electrode and a second capacitor electrode. The first capacitor electrode of the storage capacitor Cst may be electrically connected to the gate of a first transistor T1 via the second node ND2, and the second capacitor electrode of the storage capacitor Cst may be electrically connected to the first driving voltage line PL1. A charge corresponding to the difference between the gate of the first transistor T1 and the first driving voltage ELVDD1 may be stored in the storage capacitor Cst.

The auxiliary capacitor Ca may be electrically connected between the first pixel electrode PEr and the common electrode CAT of the first organic light-emitting diode OLED1. In an embodiment, the auxiliary capacitor Ca may be omitted.

Referring to FIG. 7B, the third pixel circuit PCb may include the first to seventh transistors T1 to T7, the storage capacitor Cst, and the auxiliary capacitor Ca. The third pixel circuit PCb may be a pixel circuit electrically connected to the third organic light-emitting diode OLED3. The third pixel circuit PCb may be electrically connected to a second driving voltage line PL2 instead of the first driving voltage line PL1. In an embodiment, the third pixel circuit PCb may be electrically connected to a third initialization voltage line VAIL2 instead of the second initialization voltage line VAIL1.

The third pixel circuit PCb may have a similar configuration to the first pixel circuit PCr and the second pixel circuit PCg. However, the first capacitor electrode of the storage capacitor Cst may be electrically connected to the gate of the first transistor T1 via the second node ND2, and the second capacitor electrode of the storage capacitor Cst is electrically connected to the second driving voltage lines PL2. A charge corresponding to the difference between the gate of the first transistor T1 and the second driving voltage ELVDD2 may be stored in the storage capacitor Cst.

In the third pixel circuit PCb, the gate of the fifth transistor T5 may be electrically connected to the emission control line EML, the first terminal of the fifth transistor T5 may be electrically connected to the second driving voltage lines PL2, and the second terminal of the fifth transistor T5 may be electrically connected to the first node ND1. When the fifth transistor T5 and the sixth transistor T6 is turned on simultaneously in response to the emission control signal EM transmitted through the emission control line EML, the first terminal of the first transistor T1 may receive the second driving voltage ELVDD2 through the second driving voltage line PL2.

In the third pixel circuit PCb, the gate of the seventh transistor T7 may be electrically connected to the fourth scan line GBL, the first terminal of the seventh transistor T7 may be electrically connected to the fourth node ND4, and the second terminal of the seventh transistor T7 may be electrically connected to the third initialization voltage line VAIL2. The seventh transistor T7 may be turned on in response to the fourth scan signal GB received through the fourth scan line GBL, and may initialize the third pixel electrode PEb of the third organic light-emitting diode OLED3 with the third initialization voltage Vaint2.

As described above with reference to FIGS. 6A and 6B, the third organic light-emitting diode OLED3 may further include the plurality of emission layers 333 and 333', the electron generation layer 341, the hole generation layer 343, etc. Organic light-emitting diodes having multiple emission layers may use higher driving voltage than organic light-emitting diodes having a single emission layer. However, if a high driving voltage is applied to all of the light-emitting diodes of the display apparatus 1, power consumption may increase. In an embodiment, in order to reduce or minimize the increase in power consumption, the voltage level of the first driving voltage ELVDD1, applied to the first organic light-emitting diode OLED1 and the second organic light-emitting diode OLED2, may be lower than the voltage level of the second driving voltage ELVDD2 applied to the third organic light-emitting diode OLED3.

The first pixel electrode PEr of the first organic light-emitting diode OLED1 and the second pixel electrode PEg of the second organic light-emitting diode OLED2 may be initialized with the second initialization voltage Vaint1 of the second initialization voltage line VAIL1 when the seventh transistor T7 is turned on. In an embodiment, the third pixel electrode PEb of the third organic light-emitting diode OLED3 may be initialized with the third initialization voltage Vaint2 of the third initialization voltage line VAIL2 when the seventh transistor T7 is turned on.

Since parasitic capacitances and threshold voltages for light emission between the common electrode CAT and each of the first pixel electrode PEr of the first organic light-emitting diode OLED1, the second pixel electrode PEg of the second organic light-emitting diode OLED2, and the third pixel electrode PEb of the third organic light-emitting diode OLED3 may be different, ideally, the initialization voltages applied to the first pixel electrode PEr of the first organic light-emitting diode OLED1, the second pixel electrode PEg of the second organic light-emitting diode OLED2, and the third pixel electrode PEb of the third organic light-emitting diode OLED3 may be desired to be different from each other. To this end, it is desired to separately implement an initialization voltage line electrically connected to the first pixel circuit PCr, an initialization voltage line electrically connected to the second pixel circuit PCg, and an initialization voltage line electrically connected to the third pixel circuit PCb within the display area DA. However, in the display apparatus 1, it is not easy to separately implement the initialization voltage line electrically connected to the first pixel circuit PCr, the initialization voltage line electrically connected to the second pixel circuit PCg, and the initialization voltage line electrically connected to the third pixel circuit PCb.

According to an embodiment, a display apparatus 1 may display a high-quality image by applying the second initialization voltage Vaint1 to the second initialization voltage line VAIL1 electrically connected to the first pixel circuit PCr and the second pixel circuit PCg, and applying the third initialization voltage Vaint2 different from the second initialization voltage Vaint1 to the third initialization voltage line VAIL2 electrically connected to the third pixel circuit PCb.

Referring to FIGS. 7A and 7B together, in each of the first pixel circuit PCr, the second pixel circuit PCg, and the third pixel circuit PCb, the first transistor T1 may include a lower gate (e.g., lower gate electrode). The lower gate of the first transistor T1 may be disposed below a channel region of the first transistor T1, and may reduce changes in a threshold voltage of the first transistor T1 due to external light, etc. The lower gate of the first transistor T1 is electrically connected to the first mesh structure MS1 and may receive the common driving voltage ELVDDc. In an embodiment, the common driving voltage ELVDDc may be the first driving voltage ELVDD1, as described with reference to FIGS. 4A and 4B. However, the disclosure is not limited thereto. In another embodiment, the common driving voltage ELVDDc may be the second driving voltage ELVDD2.

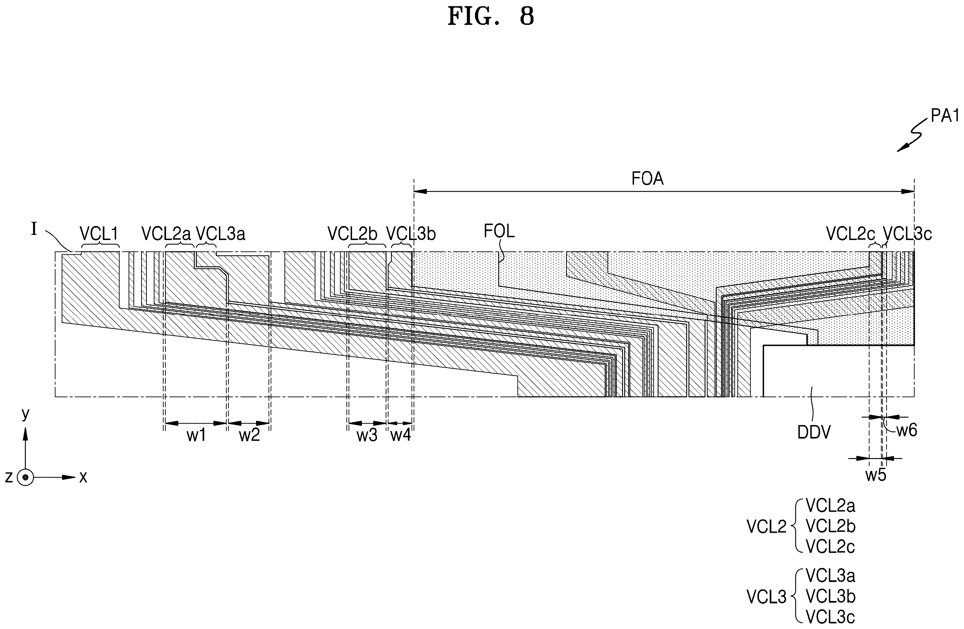

FIG. 8 is a schematic plan view illustrating an area I of the display apparatus 1 of FIG. 4B.

FIG. 8 illustrates a left portion (e.g., -x side) of the sub-region SR of the first peripheral area PA1 of the display apparatus 1 illustrated in FIG. 4B. The bending region BR may be disposed between the main region MR and the sub-region SR. In the sub-region SR, connecting lines that electrically connect the pad unit PAD1 and the signal lines or voltage supply lines to each other in the main region MR may be disposed.

Referring to FIG. 8, the voltage supply lines, the fan-out lines FOL and the data driver DDV may be disposed in the sub-region SR. The voltage connection lines may include the first voltage connection line VCL1, the second voltage connection line VCL2, and the third voltage connection line VCL3. The voltage connection lines and the fan-out lines FOL may each be symmetrical with respect to an imaginary line passing through the center of the display apparatus 1 and extending in the second direction (e.g., y-axis direction).

FIG. 8 illustrates an embodiment of a fan-out area FOA where multiple fan-out lines FOL are disposed. Each of the fan-out lines FOL may extend from the data driver DDV toward the display area DA (refer to FIG. 1) and may be electrically connected to a corresponding data line DL (refer to FIG. 3). Each of the fan-out lines FOL may include straight portions extending in the second direction (e.g., y-axis direction) and diagonal portions extending obliquely with respect to the first direction (e.g., x-axis direction) and the second direction (e.g., y-axis direction).

The first voltage connection line VCL1 may electrically connect the common voltage supply line VSSL (refer to FIG. 3) and a corresponding pad of the pad unit PAD1 (refer to FIG. 3) to each other. The first voltage connection line VCL1 may transmit the common voltage ELVSS (refer to FIGS. 7A and 7B) from the control unit to the common voltage supply line VSSL.

The second voltage connection line VCL2 may electrically connect the first driving voltage supply line VDDL1 (refer to FIG. 4B) and corresponding pads of the pad unit PAD1 to each other. The second voltage connection line VCL2 may transmit the first driving voltage ELVDD1 (refer to FIG. 7A) from the control unit to the first driving voltage supply line VDDL1.

The second voltage connection line VCL2 may include multiple sub-connection lines extending in different directions. In an embodiment, for example, the second voltage connection line VCL2 may include a first sub-connection line VCL2a, a second sub-connection line VCL2b, and a third sub-connection line VCL2c. The first sub-connection line VCL2a and the second sub-connection line VCL2b may be disposed outside the fan-out area FOA in a plan view. The first sub-connection line VCL2a may be disposed adjacent to the first voltage connection line VCL1, and the second sub-connection line VCL2b may be disposed between the first sub-connection line VCL2a and the fan-out area FOA. The third sub-connection line VCL2c may be extended to overlap the fan-out area FOA in a plan view.

Each of the first sub-connection line VCL2a, the second sub-connection line VCL2b, and the third sub-connection line VCL2c may include straight portions extending in the second direction (e.g., y-axis direction) and diagonal portions extending obliquely with respect to the first direction (e.g., x-axis direction) and the second direction (e.g., y-axis direction).

The third voltage connection line VCL3 may electrically connect the second driving voltage supply line VDDL2 (refer to FIG. 4B) and corresponding pads of the pad unit PAD1 (refer to FIG. 4B) to each other. The third voltage connection line VCL3 may transmit the second driving voltage ELVDD2 (refer to FIG. 7B) from the control unit to the second driving voltage supply line VDDL2.

The third voltage connection line VCL3 may include multiple sub-connection lines extending in different directions. In an embodiment, for example, the third voltage connection line VCL3 may include a fourth sub-connection line VCL3a, a fifth sub-connection line VCL3b, and a sixth sub-connection line VCL3c. The fourth sub-connection line VCL3a and the fifth sub-connection line VCL3b may be disposed outside the fan-out area FOA in a plan view. The fourth sub-connection line VCL3a may be disposed adjacent to the first sub-connection line VCL2a. The fourth sub-connection line VCL3a may be disposed between the first sub-connection line VCL2a and the second sub-connection line VCL2b. The fifth sub-connection line VCL3b may be disposed adjacent to the second sub-connection line VCL2b. The fifth sub-connection line VCL3b may be disposed between the second sub-connection line VCL2b and the fan-out area FOA. The sixth sub-connection line VCL3c may extend to overlap the fan-out area FOA on a plan view and may be disposed adjacent to the third sub-connection line VCL2c.

Each of the fourth sub-connection line VCL3a, the fifth sub-connection line VCL3b, and the sixth sub-connection line VCL3c may include straight portions extending in the second direction (e.g., y-axis direction) and diagonal portions extending obliquely with respect to the first direction (e.g., x-axis direction) and the second direction (e.g., y-axis direction).

The first sub-connection line VCL2a and the fourth sub-connection line VCL3a may be adjacent to each other and may be extended in parallel with each other. A width of the first sub-connection line VCL2a and a width of the fourth sub-connection line VCL3a may be different from each other. The width of each sub-connection line means the width in the direction orthogonal to the direction in which the sub-connection line extends. When the total amount of current flowing through the first pixels PXr (refer to FIG. 5) and the second pixels PXg (refer to FIG. 5) in the display apparatus 1 (refer to FIG. 1) is referred to as the first current, and the total amount of current flowing through the third pixels PXb (refer to FIG. 5) is referred to as the second current, a ratio of a width w1 of a portion of the first sub-connection line VCL2a to a width w2 of a portion of the fourth sub-connection line VCL3a corresponding thereto may be equal to the ratio of the first current to the second current. In an embodiment, the width w1 of the portion of the first sub-connection line VCL2a may be greater than the width w2 of the portion of the corresponding fourth sub-connection line VCL3a. In FIG. 8, the width w1 of the widest part of the straight portion of the first sub-connection line VCL2a and the width w2 of the widest part of the straight portion of the fourth sub-connection line VCL3a are compared as an example, but the disclosure is not limited thereto. A ratio of the width of the diagonal portion of the first sub-connection line VCL2a to the width of the corresponding diagonal portion of the fourth sub-connection line VCL3a may also be equal to the ratio of the first current and the second current.

In such an embodiment, the ratio of a width w3 of a portion of the second sub-connection line VCL2b and a width w4 of a corresponding portion of the fifth sub-connection line VCL3b that extends adjacently and parallel to each other may be equal to the ratio of the first current and the second current. The ratio of the width w5 of the portion of the third sub-connection line VCL2c and the width w6 of the corresponding portion of the sixth sub-connection line VCL3c, which extends adjacently and parallel to the third sub-connection line VCL2c, may be equal to the ratio of the first current and the second current. The display apparatus 1 according to an embodiment may effectively prevent or substantially reduce voltage drops in the first driving voltage ELVDD1 and the second driving voltage ELVDD2 by designing the line widths of each of the first, second, third, fourth, fifth and sixth sub-connection lines VCL2a, VCL2b, VCL2c, VCL3a, VCL3b, and VCL3c differently in consideration of the ratio of the current.

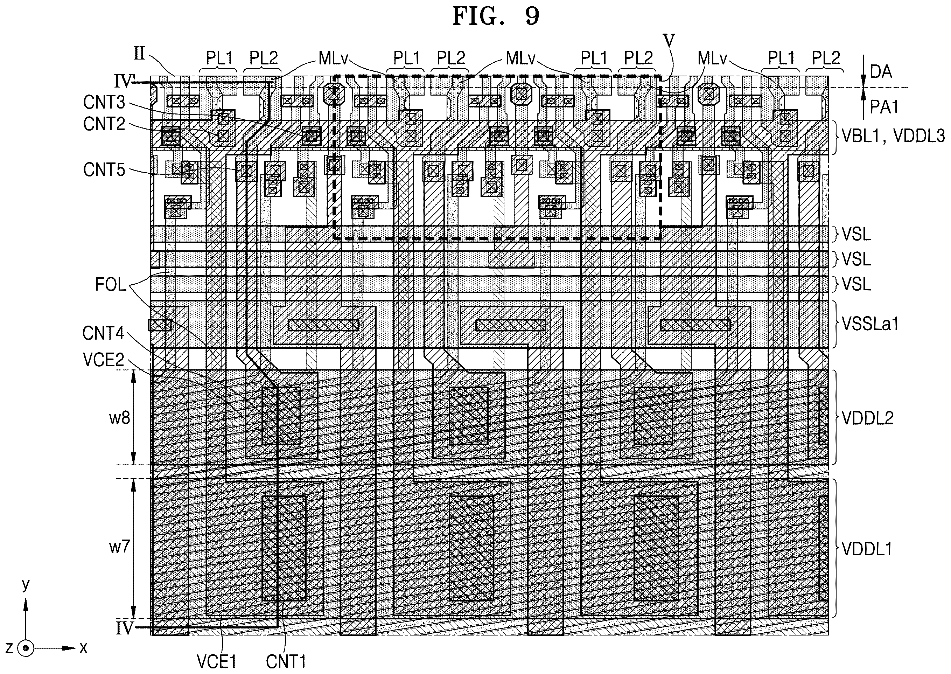

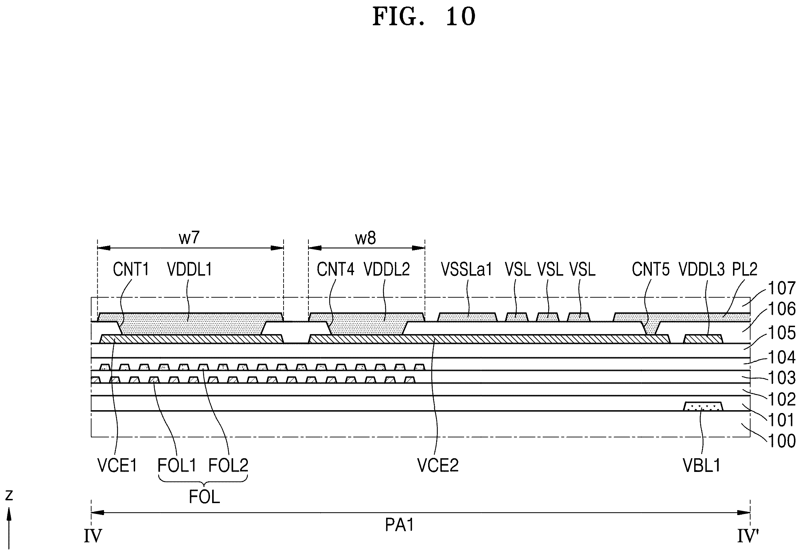

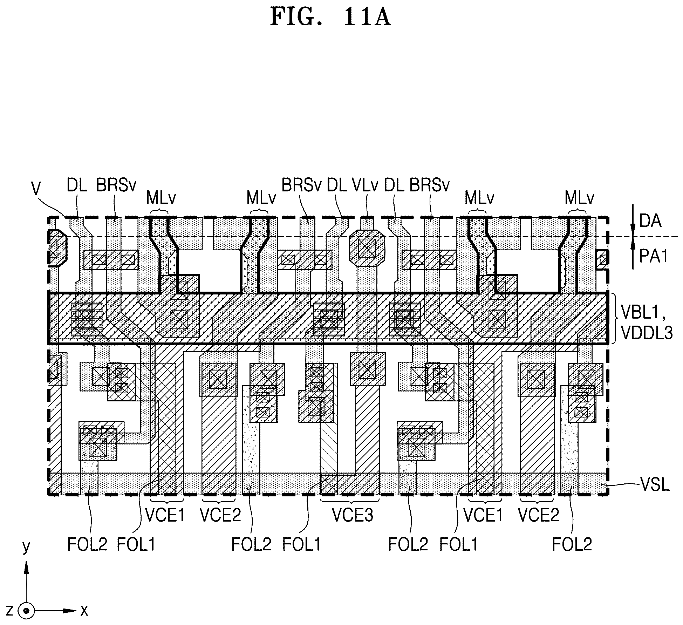

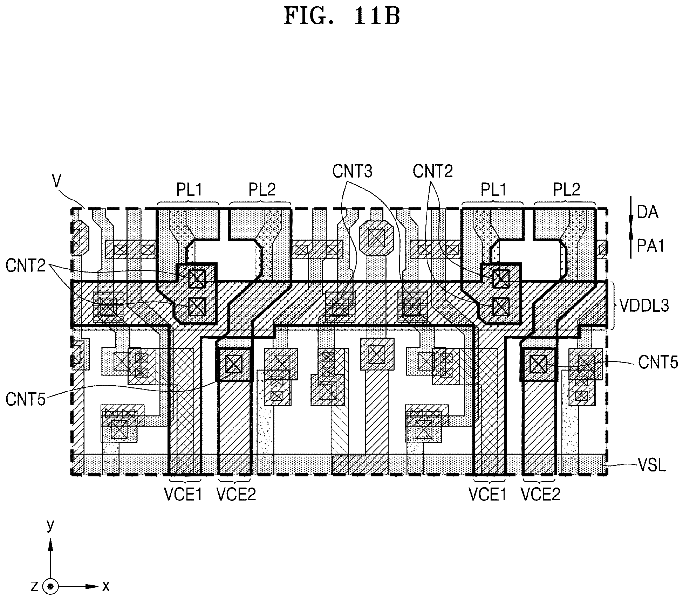

FIG. 9 is a schematic plan view illustrating an area II of the display apparatus 1 of FIG. 4B. FIG. 10 is a schematic cross-sectional view taken along line IV-IV' of the display apparatus of FIG. 9. FIGS. 11A and 11B are schematic plan views, each illustrating an area V of the display apparatus 1 of FIG. 9.

Referring to FIGS. 9 and 10, in an embodiment, the voltage supply lines and the fan-out lines FOL may be disposed in the first peripheral area PA1. The voltage supply lines may include the first driving voltage supply line VDDL1, the second driving voltage supply line VDDL2, the third driving voltage supply line VDDL3, a first auxiliary common voltage supply line VSSLa1, initialization voltage supply lines VSL, and the first bottom driving voltage supply line VBL1.

A first insulating layer 101 may be disposed on the substrate 100. The first insulating layer 101 may be a buffer layer to prevent impurities, etc. from diffusing from the substrate 100 to the semiconductor layer disposed thereon. The first insulating layer 101 may include silicon oxide, silicon nitride or silicon oxynitride.

The first conductive layer including the first bottom driving voltage supply line VBL1 may be disposed between the substrate 100 and the first insulating layer 101. The first bottom driving voltage supply line VBL1 may extend in the first direction (e.g., x-axis direction) and may be disposed adjacent to the lower (-y side) boundary of the display area DA.

The first bottom driving voltage supply line VBL1 may be electrically connected to the vertical mesh wires MLv extending to the display area DA.

Referring to FIG. 11A, the vertical mesh wires MLv may be connected to the first bottom driving voltage supply line VBL1. In an embodiment, for example, the vertical mesh wires MLv may be integrally formed with the first bottom driving voltage supply line VBL1 as a single unitary indivisible part. The vertical mesh wires MLv may be provided one for each pixel circuit column. The vertical mesh wires MLv may be electrically connected to the horizontal mesh wires MLh (refer to FIG. 4A) in the display area DA to form the first mesh structure MS1 (refer to FIG. 4A).

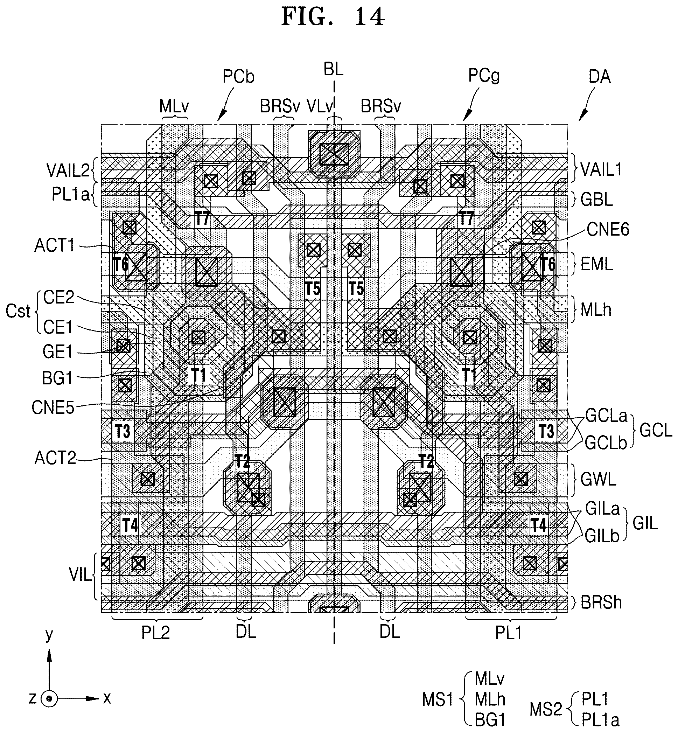

A second insulating layer 102 and a third insulating layer 103 may be sequentially disposed on the first insulating layer 101. In an embodiment, a first semiconductor layer ACT1 (refer to FIG. 14) may be disposed between the first insulating layer 101 and the second insulating layer 102 in the display area DA. Each of the second insulating layer 102 and the third insulating layer 103 may include silicon oxide, silicon nitride or silicon oxynitride.

Each of the fan-out lines FOL may have a portion extending obliquely with respect to the first direction (e.g., x-axis direction) and the second direction (e.g., y-axis direction). Each of the fan-out lines FOL may be electrically connected to a corresponding data line DL or a corresponding vertical data connection line BRSv. Herein, the vertical data connection line BRSv refers to a vertical portion of a data connection line that electrically connects a data line of a pixel circuit column disposed on the left (e.g., -x side) boundary of the display area DA or the right (e.g., +x side) boundary of the display area DA and a corresponding fan-out line.

The fan-out lines FOL may include first fan-out lines FOL1 and second fan-out lines FOL2. The first fan-out lines FOL1 and the second fan-out lines FOL2 may be arranged alternately in the second direction (e.g., y-axis direction) and may be disposed in different layers. In an embodiment, for example, the first fan-out line FOL1 may be disposed between the second insulating layer 102 and the third insulating layer 103, and the second fan-out line FOL2 may be disposed between the third insulating layer 103 and a fourth insulating layer 104.

The fourth insulating layer 104 and a fifth insulating layer 105 may be sequentially disposed on the second fan-out line FOL2. Each of the fourth insulating layer 104 and the fifth insulating layer 105 may include silicon oxide, silicon nitride or silicon oxynitride. A second semiconductor layer ACT2 (refer to FIG. 14) may be disposed between the fourth insulating layer 104 and the fifth insulating layer 105 in the display area DA.

A second conductive layer may be disposed on the fifth insulating layer 105, and the second conductive layer may include the third driving voltage supply line VDDL3 and connection electrodes. The connection electrodes may include a first connection electrode VCE1 electrically connecting the first driving voltage supply line VDDL1 and the third driving voltage supply line VDDL3, and a second connection electrode VCE2 electrically connecting the second driving voltage supply line VDDL2 and the first driving voltage line PL1.

The third driving voltage supply line VDDL3 may extend in the first direction (e.g., x-axis direction) and may be disposed adjacent to the lower (e.g., -y side) boundary of the display area DA. In a plan view, the third driving voltage supply line VDDL3 may overlap the first bottom driving voltage supply line VBL1. The third driving voltage supply line VDDL3 may be electrically connected to the first bottom driving voltage supply line VBL1 through a third contact hole CNT3 penetrating (or defined through) the first insulating layer 101, the second insulating layer 102, the third insulating layer 103, the fourth insulating layer 104, and the fifth insulating layer 105.

The first connection electrodes VCE1 may be extended from the third driving voltage supply line VDDL3 to the first driving voltage supply line VDDL1 across the initialization voltage supply lines VSL, the first auxiliary common voltage supply line VSSLa1 and the second driving voltage supply line VDDL2. The first connection electrodes VCE1 may be electrically connected to the third driving voltage supply line VDDL3. In an embodiment, for example, The first connection electrodes VCE1 may be integrally formed with the third driving voltage supply line VDDL3 as a single unitary indivisible part. Each of the second connection electrodes VCE2 may be extended from the second driving voltage supply line VDDL2 to a corresponding second driving voltage line PL2 across the first auxiliary common voltage supply line VSSLa1 and the initialization voltage supply lines VSL.

The sixth insulating layer 106 may cover the connection electrodes and the third driving voltage supply line VDDL3, and may be disposed on the fifth insulating layer 105. The sixth insulating layer 106 may include an organic insulating material. In an embodiment, for example, the sixth insulating layer 106 may include a photoresist, a benzocyclobutene (BCB), a polyimide, a hexamethyldisiloxane (HMDSO), a polymethylmethacrylate (PMMA), a polystyrene, a polymer derivative having a phenol group, an acrylic polymer, an imide polymer, an aryl ether polymer, an amide polymer, a fluorinated polymer, a p-xylene polymer, a vinyl alcohol polymer, or a mixture thereof. In an embodiment, the sixth insulating layer 106 may include an inorganic insulating material, and an upper surface thereof may not be flat.

A third conductive layer including the first driving voltage supply line VDDL1, the second driving voltage supply line VDDL2, the first auxiliary common voltage supply line VSSLa1, the initialization voltage supply lines VSL, the first driving voltage lines PL1, the second driving voltage lines PL2, the data lines DL, the vertical data connection lines BRSv, and the auxiliary voltage lines VLv may be disposed on the fifth insulating layer 105.

The first driving voltage supply line VDDL1 may extend in the first direction (e.g., x-axis direction) and overlap the fan-out lines FOL in a plan view. The first driving voltage supply line VDDL1 may be disposed on the fan-out lines FOL. The first driving voltage supply line VDDL1 may be electrically connected to the first connection electrode VCE1 through the first contact hole CNT1 penetrating the sixth insulating layer 106.

The second driving voltage supply line VDDL2 may extend in the first direction (e.g., x-axis direction) and may overlap the fan-out lines FOL in a plan view. The second driving voltage supply line VDDL2 may be disposed on the fan-out lines FOL. In a plan view, the second driving voltage supply line VDDL2 may be disposed closer to the display area DA than the first driving voltage supply line VDDL1. The second driving voltage supply line VDDL2 may be electrically connected to the second connection electrode VCE2 through the fourth contact hole CNT4 penetrating the sixth insulating layer 106.

When the total amount of current flowing through the first pixels PXr (refer to FIG. 5) and the second pixels PXg (refer to FIG. 5) in the display apparatus 1 (refer to FIG. 1) is referred to as the first current, and the total amount of current flowing through the third pixels PXb (refer to FIG. 5) is referred to as the second current, a ratio of a width w7 of the first driving voltage supply line VDDL1 along the second direction (e.g., y-axis direction) and a width w8 of the second driving voltage supply line VDDL2 along the second direction (e.g., y-axis direction) may be equal to the ratio of the first current and the second current. In an embodiment, for example, the width w7 of the first driving voltage supply line VDDL1 along the second direction (e.g., y-axis direction) may be greater than the width w8 of the second driving voltage supply line VDDL2 along the second direction (e.g., y-axis direction). By designing the widths of the first driving voltage supply line VDDL1 and the second driving voltage supply line VDDL2 to be different, the voltage drop of the first driving voltage ELVDD1 and the second driving voltage ELVDD2 may be effectively prevented or substantially reduced.

Referring to FIG. 11B, each of the first driving voltage lines PL1 may extend from the third driving voltage supply line VDDL3 to the display area DA approximately (or substantially) along the second direction (e.g., y-axis direction). Each of the first driving voltage lines PL1 may be electrically connected to the third driving voltage supply line VDDL3 through the second contact holes CNT2 penetrating the sixth insulating layer 106. The first driving voltage supply line VDDL1 may transmit the first driving voltage ELVDD1 (refer to FIG. 7A) to the first driving voltage lines PL1 via the first connection electrodes VCE1 and the third driving voltage supply line VDDL3.

Each of the second driving voltage lines PL2 may extend from the corresponding second connection electrode VCE2 to the display area DA approximately (or substantially) along the second direction (e.g., y-axis direction). Each of the second driving voltage lines PL2 may be electrically connected to the corresponding second connection electrode VCE2 through a fifth contact hole CNT5 penetrating the sixth insulating layer 106. The second driving voltage supply line VDDL2 may transmit the second driving voltage ELVDD2 (refer to FIG. 7B) to the second driving voltage lines PL2 via the second connection electrodes VCE2.

The fifth contact hole CNT5 may be defined between the second driving voltage supply line VDDL2 and the third driving voltage supply line VDDL3. The fifth contact hole CNT5 may be defined in an area between the third driving voltage supply line VDDL3 and the closest initialization voltage supply line VSL to the display area DA.

The first auxiliary common voltage supply line VSSLa1 may extend in the first direction (e.g., x-axis direction) and may transmit the common voltage ELVSS (refer to FIGS. 7A and 7B). The initialization voltage supply lines VSL may extend in the first direction (e.g., x-axis direction) and each may transmit a corresponding one of the first initialization voltage Vint (refer to FIGS. 7A and 7B), the second initialization voltage Vaint1 (refer to FIG. 7A), and the third initialization voltage Vaint2 (refer to FIG. 7B), respectively. Each of the first auxiliary common voltage supply line VSSLa1 and the initialization voltage supply lines VSL may be electrically connected to a corresponding one of the auxiliary voltage lines VLv through connection electrodes. The auxiliary voltage lines VLv may extend approximately (or substantially) along the second direction (e.g., y-axis direction) to the display area DA.

The first driving voltage lines PL1 and the second driving voltage lines PL2 may be disposed in the first direction (e.g., x-axis direction) according to a predefined rule. In an embodiment, as illustrated in FIG. 9 and FIG. 11B, the first driving voltage lines PL1 and the second driving voltage lines PL2 may be arranged alternately with each other. However, the disclosure is not limited thereto.

A seventh insulating layer 107 may cover the first driving voltage supply line VDDL1, the second driving voltage supply line VDDL2, the first auxiliary common voltage supply line VSSLa1, the initialization voltage supply lines VSL, and the third driving voltage supply line VDDL3, and may be disposed on the sixth insulating layer 106. The seventh insulating layer 107 may contain organic insulating materials. In an embodiment, for example, the seventh insulating layer 107 may include a photoresist, a benzocyclobutene (BCB), a polyimide, a hexamethyldisiloxane (HMDSO), a polymethylmethacrylate (PMMA), a polystyrene, a polymer derivative having a phenol group, an acrylic polymer, an imide polymer, an aryl ether polymer, an amide polymer, a fluorinated polymer, a p-xylene polymer, a vinyl alcohol polymer, or a mixture thereof.

Organic light-emitting diodes may be disposed on the seventh insulating layer 107.

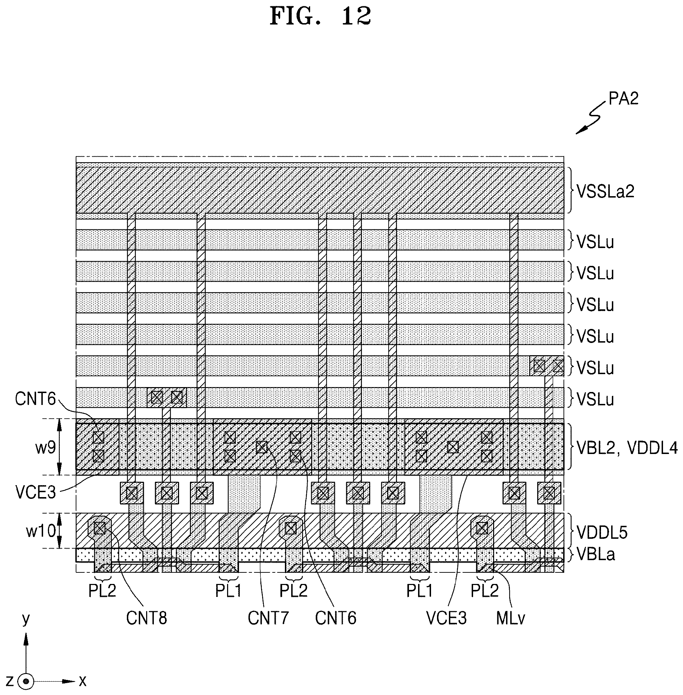

FIG. 12 is a schematic plan view of a portion of a display apparatus 1 according to an embodiment.

Referring to FIG. 12, in an embodiment, a second auxiliary common voltage supply line VSSLa2, upper initialization voltage supply lines VSLu, the fourth driving voltage supply line VDDL4, the fifth driving voltage supply line VDDL5, the second bottom driving voltage supply line VBL2, and the auxiliary driving voltage supply line VBLa may be disposed in the second peripheral area PA2. The second auxiliary common voltage supply line VSSLa2, the upper initialization voltage supply lines VSLu, the fourth driving voltage supply line VDDL4, and the fifth driving voltage supply line VDDL5 may be disposed to be spaced apart from each other in the second direction (e.g., y-axis direction).

The second auxiliary common voltage supply line VSSLa2 may extend in the first direction (e.g., x-axis direction) and may transmit the common voltage ELVSS (refer to FIGS. 7A and 7B). The second auxiliary common voltage supply line VSSLa2 may be electrically connected to corresponding auxiliary voltage lines and data lines through connection electrodes. The auxiliary voltage lines and data lines may extend approximately (or substantially) along the second direction (e.g., y-axis direction) to the display area DA.

The upper initialization voltage supply lines VSLu may extend in the first direction (e.g., x-axis direction) and may transmit one of the first initialization voltage Vint, the second initialization voltage Vaint1, and the third initialization voltage Vaint2, respectively. In an embodiment, the number of upper initialization voltage supply lines VSLu disposed in the second peripheral area PA2 may be different from the number of initialization voltage supply lines VSL (refer to FIG. 9) disposed in the first peripheral area PA1(refer to FIG. 9). The display apparatus 1 may further include a component area in which components, etc. are placed under the substrate 100. The upper initialization voltage supply lines VSLu may further include voltage lines for transmitting initialization voltages applied to pixel circuits disposed in the component area. Each of the upper initialization voltage supply lines VSLu may be electrically connected to corresponding auxiliary voltage lines through connection electrodes.

The fourth driving voltage supply line VDDL4 may extend in the first direction (e.g., x-axis direction). The fourth driving voltage supply line VDDL4 may be electrically connected to the first driving voltage lines PL1 extending approximately (or substantially) along the second direction (e.g., y-axis direction) to the display area DA. The fourth driving voltage supply line VDDL4 may be electrically connected to the first driving voltage lines PL1. In an embodiment, for example, the fourth driving voltage supply line VDDL4 may be integrally formed with the first driving voltage lines PL1 as a single unitary indivisible part.

The second bottom driving voltage supply line VBL2 may be disposed below the fourth driving voltage supply line VDDL4. In a plan view, the fourth driving voltage supply line VDDL4 may overlap the second bottom driving voltage supply line VBL2. Third connection electrodes VCE3 may be disposed between the second bottom driving voltage supply line VBL2 and the fourth driving voltage supply line VDDL4.

The second bottom driving voltage supply line VBL2 may be included in the first conductive layer, the third connection electrode VCE3 may be included in the second conductive layer, and the fourth driving voltage supply line VDDL4 may be included in the third conductive layer. At least one insulating layer, for example, the sixth insulating layer 106 (refer to FIG. 10), may be disposed between the fourth driving voltage supply line VDDL4 and the third connection electrodes VCE3. The fourth driving voltage supply line VDDL4 may be electrically connected to the third connection electrodes VCE3 through sixth contact holes CNT6 penetrating the at least one of the insulating layers.

The at least one insulating layer, for example, the first insulating layer 101 (refer to FIG. 10), the second insulating layer 102 (refer to FIG. 10), the third insulating layer 103 (refer to FIG. 10), the fourth insulating layer 104 (refer to FIG. 10), and the fifth insulating layer 105 (refer to FIG. 10) may be disposed between the third connection electrodes VCE3 and the second bottom driving voltage supply line VBL2. Each of the third connection electrodes VCE3 may be electrically connected to the second bottom driving voltage supply line VBL2 through a seventh contact hole CNT7 penetrating at least one insulating layer.

Referring to FIG. 4B and FIG. 9 together, one end of each of the first driving voltage lines PL1 may be electrically connected to the third driving voltage supply line VDDL3 in the first peripheral area PA1, and the other end of each of the first driving voltage lines PL1 may be connected to the fourth driving voltage supply line VDDL4 in the second peripheral area PA2. By providing double wiring of the fourth driving voltage supply line VDDL4 and the second bottom driving voltage supply line VBL2, the voltage drop of the first driving voltage ELVDD1 (refer to FIG. 7A) may be substantially reduced or minimized throughout the display area DA.

The fifth driving voltage supply line VDDL5 may extend in the first direction (e.g., x-axis direction). The fifth driving voltage supply line VDDL5 may be electrically connected to the second driving voltage lines PL2 extending approximately (or substantially) along the second direction (e.g., y-axis direction) to the display area DA. The fifth driving voltage supply line VDDL5 may be included in the second conductive layer, and the second driving voltage lines PL2 may be included in the third conductive layer. At least one insulating layer, for example, the sixth insulating layer 106 (refer to FIG. 10), may be disposed between the second driving voltage lines PL2 and the fifth driving voltage supply lines VDDL5. Each of the second driving voltage lines PL2 may be electrically connected to the fifth driving voltage supply line VDDL5 through an eighth contact hole CNT8 penetrating the at least one insulating layer.

Referring to FIG. 4B and FIG. 9 together, one end of each of the second driving voltage lines PL2 may be electrically connected to the second driving voltage supply line VDDL2 in the first peripheral area PA1, and an opposing end of each of the second driving voltage lines PL2 may be electrically connected to the fifth driving voltage supply line VDDL5 in the second peripheral area PA2. By providing the fifth driving voltage supply line VDDL5, the voltage drop of the second driving voltage ELVDD2 (refer to FIG. 7B) at the upper part of the display area DA may be substantially reduced or minimized.

When the total amount of current flowing through the first pixels PXr (refer to FIG. 5) and the second pixels PXg (refer to FIG. 5) in the display apparatus 1 (refer to FIG. 1) is referred to as the first current, and the total amount of current flowing through the third pixels PXb (refer to FIG. 5) is referred to as the second current, a ratio of a width w9 of the fourth driving voltage supply line VDDL4 along the second direction (e.g., y-axis direction) and a width w10 of the fifth driving voltage supply line VDDL10 along the second direction (e.g., y-axis direction) may be equal to the ratio of the first current and the second current. By designing the widths of the fourth driving voltage supply line VDDL4 and the fifth driving voltage supply line VDDL5 to be different, the voltage drop of the first driving voltage ELVDD1 (refer to FIG. 7A) and the second driving voltage ELVDD2 (refer to FIG. 7B) may be effectively prevented or substantially reduced.

The auxiliary driving voltage supply line VBLa may be disposed adjacent to the display area DA (refer to FIG. 4B). The auxiliary driving voltage supply line VBLa may extend in the first direction (e.g., x-axis direction). The auxiliary driving voltage supply line VBLa may be electrically connected to the vertical mesh wires MLv extending approximately (or substantially) along the second direction (e.g., y-axis direction) to the display area DA. The auxiliary driving voltage supply line VBLa and the vertical mesh wires MLv may be integrally formed with each other as a single unitary indivisible part.

Referring to FIG. 4A and FIG. 11A together, one end of each of the vertical mesh wires MLv may be electrically connected to the first bottom driving voltage supply line VBL1 in the first peripheral area PA1, and the other end of each of the vertical mesh wires MLv may be electrically connected to the auxiliary driving voltage supply line VBLa in the second peripheral area PA2. By providing the auxiliary driving voltage supply line VBLa, the voltage drop of the common driving voltage ELVDDc at the upper part of the display area DA may be substantially reduced or minimized. In an embodiment, the common driving voltage ELVDDc may be the first driving voltage ELVDD1.

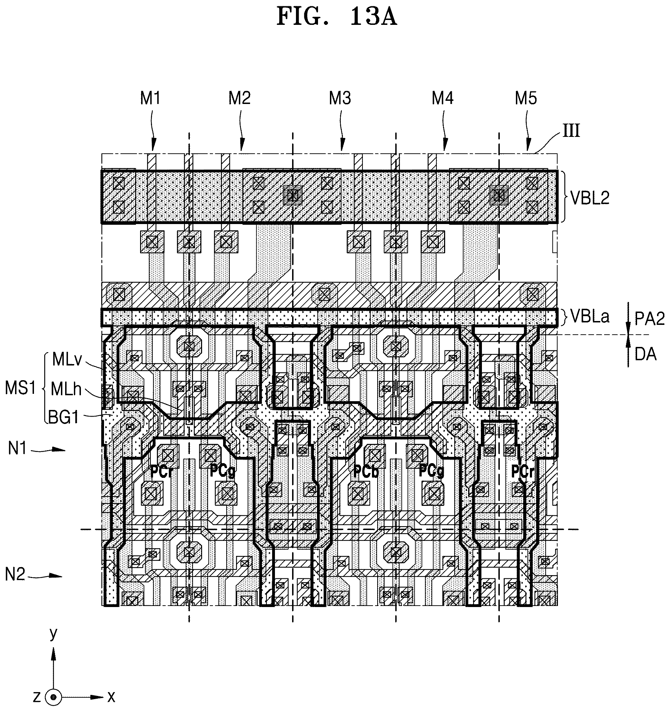

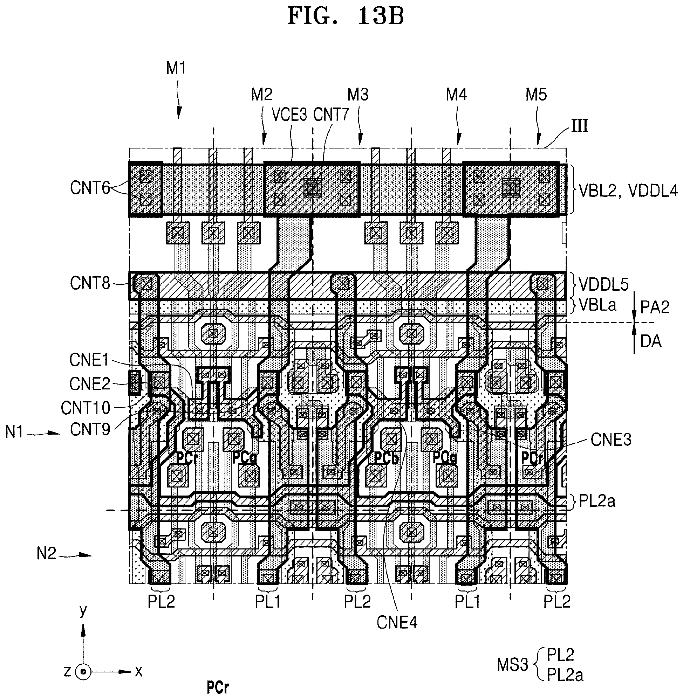

FIGS. 13A and 13B are schematic plan views, each illustrating an area III of the display apparatus of FIG. 4B.

Referring to FIGS. 13A and 13B, the second bottom driving voltage supply line VBL2, the auxiliary driving voltage supply line VBLa, the fourth driving voltage supply line VDDL4, and the fifth driving voltage supply line VDDL5 may be disposed in the second peripheral area PA2.

In the display area DA, the first pixel circuits PCr, the second pixel circuits PCg, and the third pixel circuits PCb may be arranged in a matrix form along the first direction (e.g., x-axis direction) and the second direction (e.g., y-axis direction). In FIGS. 13A and 13B, the approximate boundaries of the first and second rows N1 and N2, and first, second, third, fourth and fifth columns M1, M2, M3, M4, and M5 are drawn with dotted lines. For example, in the first row N1, one of the first pixel circuits PCr, one of the second pixel circuits PCg, a third pixel circuits PCb, one of the second pixel circuits PCg, and one of the first pixel circuit PCsr may be sequentially arranged along the first direction (e.g., x-axis direction).

The second bottom driving voltage supply line VBL2 may extend along the first direction (e.g., x-axis direction). The auxiliary driving voltage supply line VBLa may be disposed between the second bottom driving voltage supply line VBL2 and the display area DA. The auxiliary driving voltage supply line VBLa may extend in the first direction (e.g., x-axis direction) and may be adjacent to the boundary of the display area DA.

The auxiliary driving voltage supply line VBLa may be electrically connected to the vertical mesh wires MLv extending approximately (or substantially) along the second direction (e.g., y-axis direction) to the display area DA. The vertical mesh wires MLv may be disposed in each pixel circuit column. Each of the horizontal mesh wires MLh may extend approximately (or substantially) along the first direction (e.g., x-axis direction) and may be disposed in each pixel circuit row. In the display area DA, the vertical mesh wires MLv and the horizontal mesh wires MLh may intersect each other. A lower gate electrode BG1 may be disposed in an area where the vertical mesh wires MLv and the horizontal mesh wires MLh intersect. A lower gate electrode BG1 may be disposed below the channel region of the first transistor T1 (refer to FIGS. 7A and 7B), thereby reducing a change in the threshold voltage of the first transistor T1 due to external light, etc., and preventing deterioration of the first transistor T1.

The vertical mesh wires MLv, the horizontal mesh wires MLh, and the lower gate electrode BG1 may be connected to each other to form the first mesh structure MS1. The auxiliary driving voltage supply line VBLa may be electrically connected to the vertical mesh wires MLv, and the auxiliary driving voltage supply line VBLa may be electrically connected to the second bottom driving voltage supply line VBL2, so that the second bottom driving voltage supply line VBL2, the auxiliary driving voltage supply line VBLa, and the first mesh structure MS1 may be integrally formed with each other as a single unitary indivisible part.

The fourth driving voltage supply line VDDL4 may extend along the first direction (e.g., x-axis direction) and may overlap the second bottom driving voltage supply line VBL2 in a plan view. The fourth driving voltage supply line VDDL4 may be disposed on the second bottom driving voltage supply line VBL2, and the third connection electrodes VCE3 may be disposed between the fourth driving voltage supply line VDDL4 and the second bottom driving voltage supply line VBL2.

The fourth driving voltage supply line VDDL4 may be electrically connected to the third connection electrodes VCE3 through the sixth contact holes CNT6, and each of the third connection electrodes VCE3 may be electrically connected to the second bottom driving voltage supply line VBL2 through the seventh contact hole CNT7.

The fourth driving voltage supply line VDDL4 and the first driving voltage lines PL1, which extends approximately (or substantially) in the second direction (e.g., y-axis direction) may be integrally formed with each other as a single unitary indivisible part. In an embodiment, the first driving voltage lines PL1 may be arranged in even-numbered columns (for example, the second and fourth pixel circuit columns M2 and M4) and may be electrically connected to the first pixel circuits PCr and the second pixel circuits PCg.

In an embodiment, for example, the first first driving voltage line PL1 arranged in the second column M2 may be electrically connected to the first node connection electrode CNE1 through the ninth contact hole CNT9 penetrating the sixth insulating layer 106 (refer to FIG. 10). The first node connection electrode CNE1 may be electrically connected to the first pixel circuit PCr arranged in the first row N1 and the first column M1 and to the second pixel circuit PCg arranged in the first row N1 and the second column M2. The first node connection electrode CNE1 may electrically connect the first terminal of the fifth transistor T5 (refer to FIG. 4A) and the second capacitor electrode of the storage capacitor Cst (refer to FIG. 4A) of each of the first pixel circuit PCr and the second pixel circuit PCg to the first driving voltage line PL1. The first pixel circuit PCr arranged in the first row N1 and first column M1 may not overlap the first driving voltage line PL1, but may be electrically connected to the adjacent first driving voltage line PL1 through the first node connection electrode CNE1 and may receive the first driving voltage ELVDD1 (refer to FIG. 7A).

The second first driving voltage line PL1 arranged in the fourth column M4 may be electrically connected to a third node connection electrode CNE3. The third node connection electrode CNE3 may be electrically connected only to the second pixel circuit PCg arranged in the fourth column M4 of the first row N1.

The fifth driving voltage supply line VDDL5 may extend in the first direction (e.g., x-axis direction). In a plan view, the fifth driving voltage supply line VDDL5 may be disposed closer to the display area DA than the fourth driving voltage supply line VDDL4. In a plan view, the fifth driving voltage supply line VDDL5 may be disposed between the fourth driving voltage supply line VDDL4 (or the second lower driving voltage supply line, VBL2) and the auxiliary driving voltage supply line VBLa.

The second driving voltage lines PL2 may extend from the fifth driving voltage supply line VDDL5 approximately (or substantially) along the second direction (e.g., y-axis direction) to the display area DA. Each of the second driving voltage lines PL2 may be electrically connected to the fifth driving voltage supply line VDDL5 through an eighth contact hole CNT8 penetrating the sixth insulating layer 106 (refer to FIG. 10). In an embodiment, the second driving voltage lines PL2 may be arranged in odd-numbered columns (for example, the first, third and fifth columns M1, M3, and M5) and may be electrically connected to third pixel circuits PCb. The second driving voltage lines PL2 may be electrically connected to the second auxiliary driving voltage lines PL2a extending in the first direction (e.g., x-axis direction) to form the third mesh structure MS3.

The first second driving voltage line PL2 arranged in the first column M1 may be electrically connected to the second node connection electrode CNE2 through a tenth contact hole CNT10 penetrating the sixth insulating layer 106. The second node connection electrode CNE2 may not be electrically connected to the pixel circuit, and extends approximately (or substantially) in the second direction (e.g., y-axis direction) to be connected to the second auxiliary driving voltage line PL2a.

The second second driving voltage line PL2 arranged in the third column M3 may be electrically connected to the fourth node connection electrode CNE4. The fourth node connection electrode CNE4 may be electrically connected to the third pixel circuit PCb arranged in the third column M3 of the first row N1. The fourth node connection electrode CNE4 may be an electrode that electrically connects the first terminal of the fifth transistor T5 (refer to FIG. 4B) and the second capacitor electrode of the storage capacitor Cst (refer to FIG. 4B) of the third pixel circuit PCb to the second driving voltage line PL2. The fourth node connection electrode CNE4 may extend approximately (or substantially) in the second direction (e.g., y-axis direction) and may be connected to the second auxiliary driving voltage line PL2a. In an embodiment, the second auxiliary driving voltage line PL2a, the second node connection electrode CNE2, and the fourth node connection electrode CNE4 may be integrally form with each other as a single unitary indivisible part.

FIGS. 13A and 13B each illustrates the connection relationship between the first driving voltage line PL1, the second driving voltage lines PL2, the second auxiliary driving voltage line PL2a, and the first node connection electrode CNE1, the second node connection electrode CNE2, the third node connection electrode CNE3, and the fourth node connection electrode CNE4 in the display area DA, but the disclosure is not limited thereto. Within the technical concept of the disclosure, the arrangement and connection of the driving voltage lines, auxiliary driving voltage lines, and node connection electrodes may be designed in various ways.

FIG. 14 is a schematic plan view of pixel circuits of the display apparatus 1 according to an embodiment.

Referring to FIG. 14, pixel circuits may be disposed in the display area DA of the display apparatus 1 (refer to FIG. 1). Particularly, FIG. 14 illustrates the third pixel PXb and the second pixel PXg arranged adjacently in a same row. The second pixel circuit PCg may be disposed on the right side (e.g., +x side) of the third pixel circuit PCb, and the first pixel circuit PCr (refer to FIG. 7A) may be disposed on the right side (e.g., +x side) of the second pixel circuit PCg. The third pixel circuit PCb and the second pixel circuit PCg may be approximately symmetrical with respect to an imaginary line BL extending along the boundary between the third pixel circuit PCb and the second pixel circuit PCg. The first pixel circuit PCr arranged on the right (e.g., +x side) of the second pixel circuit PCg may have a substantially same structure as the third pixel circuit PCb.

Each of the second pixel circuit PCg and the third pixel circuit PCb may include the first to seventh transistors T1 to T7 and the storage capacitor Cst. Hereinafter, for convenience of description, some components are described based on the third pixel circuit PCb, and these components may be arranged symmetrically or identically in the second pixel circuit PCg and the first pixel circuit PCr.

The first conductive layer may be disposed on the substrate 100 (refer to FIG. 1). The first conductive layer may include the first mesh structure MS1. The first mesh structure MS1 may include the vertical mesh wires MLv extending in the second direction (e.g., y-axis direction), the horizontal mesh wires MLh extending in the first direction (e.g., x-axis direction), and the lower gate electrodes BG1. The lower gate electrode BG1 may be disposed in an area where the vertical mesh wires MLv and the horizontal mesh wires MLh intersect, and the lower gate electrode BG1 may overlap the channel area of the first transistor T1 in a plan view. The vertical mesh wires MLv, horizontal mesh wires MLh and lower gate electrodes BG1 forming the first mesh structure MS1 may be integrally formed with each other as a single unitary indivisible part over the display area DA. The common driving voltage ELVDDc may be transmitted to the lower gate electrode BG1 of the first transistor T1 of each of the first pixel circuit PCr, the second pixel circuit PCg, and the third pixel circuit PCb through the first mesh structure MS1. In an embodiment, the common driving voltage ELVDDc may be the first driving voltage ELVDD1. In another embodiment, the common driving voltage ELVDDc may be the second driving voltage ELVDD2.

The first semiconductor layer ACT1 may be disposed on the first conductive layer. At least one insulating layer (e.g., the first insulating layer, 101) may be disposed between the first conductive layer and the first semiconductor layer ACT1. The first semiconductor layer ACT1 may include the channel region of the first transistor T1, a channel region of the second transistor T2, a channel region of the fifth transistor T5, a channel region of the sixth transistor T6, and a channel region of the seventh transistor T7. A source region and a drain region may be arranged on opposite sides of each of the channel region of the first transistor T1, the channel region of the second transistor T2, the channel region of the fifth transistor T5, the channel region of the sixth transistor T6, and the channel region of the seventh transistor T7.

A first gate electrode layer may be disposed on the first semiconductor layer ACT1. At least one insulating layer (e.g., a second insulating layer, 102) may be disposed between the first semiconductor layer ACT1 and the first gate electrode layer. The first gate electrode layer may include an upper gate electrode GE1 of the first transistor T1, the first scan line GWL, the fourth scan line GBL, the emission control line EML, and the first initialization voltage line VIL.

The upper gate electrode GE1 of the first transistor T1 may overlap the channel region of the first transistor T1 in a plan view.

The first scan line GWL may extend approximately (or substantially) in the first direction (e.g., x-axis direction) and may transmit the first scan signal GW (refer to FIGS. 7A and 7B). A portion of the first scan line GWL that overlaps the channel region of the second transistor T2 in a plan view may function as a gate electrode of the second transistor T2.

The emission control line EML may extend approximately (or substantially) in the first direction (e.g., x-axis direction) and may transmit the emission control signal EM (refer to FIGS. 7A and 7B). A portion of the emission control line EML overlapping the channel region of the fifth transistor T5 in a plan view may function as a gate electrode of the fifth transistor T5, and the portion of the emission control line EML overlapping the channel region of the sixth transistor T6 in a plan view may function as a gate electrode of the sixth transistor T6.

The fourth scan line GBL may extend approximately (or substantially) in the first direction (e.g., x-axis direction) and may transmit the fourth scan signal GB (refer to FIGS. 7A and 7B). A portion of the fourth scan line GBL overlapping the channel region of the seventh transistor T7 in a plan view may function as a gate electrode of the seventh transistor T7.

The first initialization voltage line VIL may extend approximately (or substantially) in the first direction (e.g., x-axis direction) and may transmit the first initialization voltage Vint (refer to FIGS. 7A and 7B). The first initialization voltage line VIL may be electrically connected to the source region of the fourth transistor T4 through the connection electrode.

A second gate electrode layer may be disposed on the first gate electrode layer. At least one insulating layer (e.g., a third insulating layer) may be disposed between the first gate electrode layer and the second gate electrode layer. The second gate electrode layer may include a second lower scan line GCLb, a third lower scan line GILb, the second initialization voltage line VAIL1, and a second capacitor electrode CE2.

The second semiconductor layer ACT2 may be disposed on the second gate electrode layer. At least one insulating layer (e.g., a fourth insulating layer, 104) may be disposed between the second gate electrode layer and the second semiconductor layer ACT2. The second semiconductor layer ACT2 may include a channel region of a third transistor T3 and a channel region of a fourth transistor T4. A source region and a drain region may be arranged on opposite sides of each of the channel region of the third transistor T3 and the channel region of the fourth transistor T4.

The second capacitor electrode CE2 may overlap in a plan view with the upper gate electrode GE1 of the first transistor T1. The upper gate electrode GE1 of the first transistor T1 functions as a first capacitor electrode CE1, and the first capacitor electrode CE1 and the second capacitor electrode CE2 may form a storage capacitor Cst.

The second lower scan line GCLb may extend approximately (or substantially) in the first direction (e.g., x-axis direction) and may transmit the second scan signal GC (refer to FIGS. 7A and 7B). A portion of the second lower scan line GCLb overlapping the channel region of the third transistor T3 in a plan view may function as a lower gate electrode of the third transistor T3.

The third lower scan line GILb may extend approximately (or substantially) in the first direction (e.g., x-axis direction) and may transmit the third scan signal GI (refer to FIGS. 7A and 7B). A portion of the third lower scan line GILb overlapping the channel region of the fourth transistor T4 in a plan view may function as a lower gate electrode of the fourth transistor T4.

The second initialization voltage line VAIL1 may extend approximately (or substantially) in the first direction (e.g., x-axis direction) and may transmit the second initialization voltage Vaint1 (refer to FIG. 7A). The second initialization voltage line VAIL1 may be electrically connected to the drain region of the seventh transistor T7 of the second pixel circuit PCg or the first pixel circuit PCr (refer to FIG. 7A) through the connection electrode.

A third gate electrode layer may be disposed on the second semiconductor layer ACT2. At least one insulating layer may be disposed between the second semiconductor layer ACT2 and the third gate electrode layer. The third gate electrode layer may include a second upper scan line GCLa, a third upper scan line GILa, and the third initialization voltage line VAIL2.

The second upper scan line GCLa may extend approximately (or substantially) in the first direction (e.g., x-axis direction) and may transmit the second scan signal GC (refer to FIGS. 7A and 7B). In a plan view, a portion of the second upper scan line GCLa overlapping the channel region of the third transistor T3 may function as an upper gate electrode of the third transistor T3. The second scan line GCL may be formed or defined by a double wiring including the second upper scan line GCLa and the second lower scan line GCLb.

The third upper scan line GILa may extend approximately (or substantially) in the first direction (e.g., x-axis direction) and may transmit the third scan signal GI (refer to FIGS. 7A and 7B). In a plan view, a portion of the third upper scan line GILa overlapping the channel region of the fourth transistor T4 may function as an upper gate electrode of the fourth transistor T4. The third scan line GIL may be formed or defined by a double wiring including the third upper scan line GILa and the third lower scan line GILb.

The third initialization voltage line VAIL2 may extend approximately (or substantially) in the first direction (e.g., x-axis direction) and may transmit the third initialization voltage Vaint2 (refer to FIG. 7B). The third initialization voltage line VAIL2 may overlap the second initialization voltage line VAIL1 in a plan view. The third initialization voltage line VAIL2 may be electrically connected to the drain region of the seventh transistor T7 of the third pixel circuit PCb through the connection electrode.

The second conductive layer may be disposed on the third gate electrode layer. At least one insulating layer (e.g., a fifth insulating layer) may be disposed between the third gate electrode layer and the second conductive layer. The second conductive layer may include the first auxiliary driving voltage line PL1a, the horizontal data connection line BRSh, and the connection electrodes. The connection electrodes may be defined by conductive patterns for electrically connecting components disposed in different layers, and may include a fifth node connection electrode CNE5 and a sixth node connection electrode CNE6.

The third conductive layer may be disposed on the second conductive layer. At least one insulating layer (e.g., a sixth insulating layer, 106) may be disposed between the second conductive layer and the third conductive layer. The third conductive layer may include the first driving voltage line PL1, the second driving voltage line PL2, the vertical data connection lines BRSv, the data lines DL, and the auxiliary voltage lines VLv.

Each of the second driving voltage lines PL2 and the first driving voltage line PL1 may extend approximately (or substantially) in the second direction (e.g., y-axis direction) and may be arranged alternately along the first direction (e.g., x-axis direction). In an embodiment, for example, The second driving voltage lines PL2 may overlap the third pixel circuit PCb in a plan view, and the first driving voltage line PL1 may overlap the second pixel circuit PCg in a plan view.

The second driving voltage lines PL2 may be electrically connected to the source region of the fifth transistor T5 of the third pixel circuit PCb and the second capacitor electrode CE2 of the storage capacitor Cst of the third pixel circuit PCb through the fifth node connection electrode CNE5.

The first driving voltage line PL1 may be electrically connected to the source region of the fifth transistor T5 of the second pixel circuit PCg and the second capacitor electrode CE2 of the storage capacitor Cst of the second pixel circuit PCg through the sixth node connection electrode CNE6.

The sixth node connection electrode CNE6 may be connected to the first auxiliary driving voltage line PL1a. The first auxiliary driving voltage line PL1a may extend approximately (or substantially) in the first direction (e.g., x-axis direction) and may be electrically connected to the first driving voltage line PL1 through the sixth node connection electrode CNE6 to form the second mesh structure MS2. The sixth node connection electrode CNE6 may be extended to the first pixel circuit PCr (refer to FIG. 7A) located on the right side (e.g., +x side) of the second pixel circuit PCg. The sixth node connection electrode CNE6 may be electrically connected to the source region of the fifth transistor T5 of the first pixel circuit PCr and the second capacitor electrode CE2 of the storage capacitor Cst of the first pixel circuit PCr. The first pixel circuit PCr may not overlap the first driving voltage line PL1, but may receive the first driving voltage ELVDD1 (refer to FIG. 7A) from the adjacent first driving voltage line PL1 through the sixth node connection electrode CNE6.

Each of the vertical data connection lines BRSv may extend approximately(or substantially) in the second direction (e.g., y-axis direction) and may be electrically connected to a corresponding horizontal data connection line BRSh. The horizontal data connection line BRSh may extend approximately (or substantially) in the first direction (e.g., x-axis direction) and may be electrically connected to a corresponding data line DL.

The data line DL may extend approximately (or substantially) in the second direction (e.g., y-axis direction) and may transmit the data voltage Vdata (refer to FIGS. 7A and 7B). The data line DL may be electrically connected to the source region of the second transistor T2 through the connection electrode.

The auxiliary voltage line VLv may extend approximately (or substantially) in the second direction (e.g., y-axis direction) and may be disposed at the boundary between the third pixel circuit PCb and the second pixel circuit PCg. The auxiliary voltage line VLv may be electrically connected to any one of the first initialization voltage line VIL, the second initialization voltage line VAIL1, the third initialization voltage line VAIL2, or the auxiliary common voltage line to form a mesh structure. FIG. 14 illustrates an embodiment where the auxiliary voltage line VLv is electrically connected to the second initialization voltage line VAIL1 through the connection electrode.

While forming the second mesh structure MS2 that transmits the first driving voltage ELVDD1 (refer to FIG. 7A) and the third mesh structure MS3 (refer to FIG. 4B) that transmits the second driving voltage supply line VDDL2 (refer to FIG. 7B), the arrangement and shape of the first driving voltage line PL1, the second driving voltage lines PL2, the first auxiliary driving voltage line PL1a, the second auxiliary driving voltage line PL2a (refer to FIG. 4B), and the node connection electrodes may be designed in various ways to transmit the voltage required for each pixel circuit.

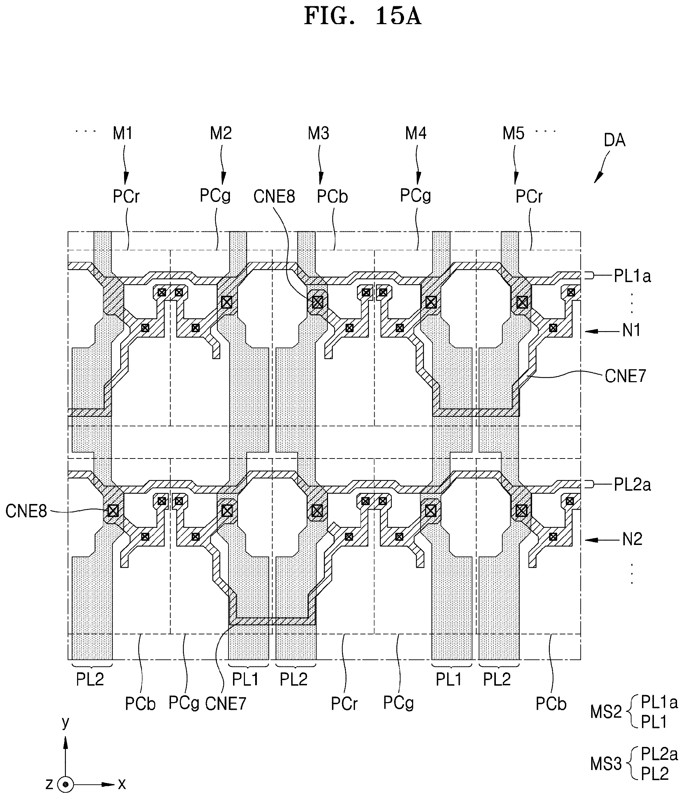

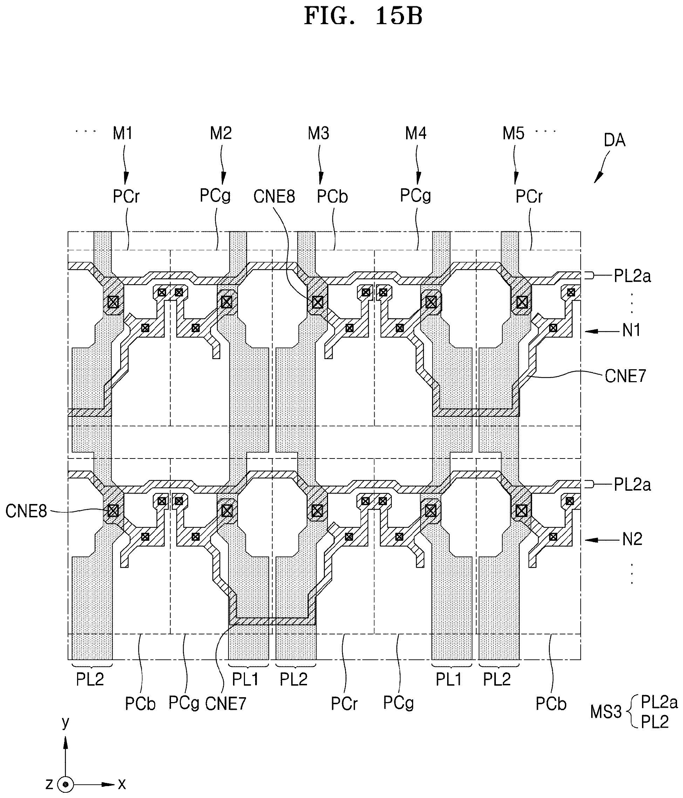

FIGS. 15A and 15B are schematic plan views, each illustrating a mesh structure of the display apparatus 1 according to an embodiment.

Referring to FIG. 15A, the first, second and third pixel circuits PCr, PCg, and PCb may be arranged in a matrix form along the first direction (e.g., x-axis direction) and the second direction (e.g., y-axis direction) in the display area DA. In FIG. 15A, the approximate boundaries of the first and second rows N1 and N2, and the first, second, third, fourth and fifth columns M1, M2, M3, M4, and M5 are drawn with dotted lines. For example, in the first row N1, one of the first pixel circuits PCr, one of the second pixel circuits PCg, one of the third pixel circuits PCb, one of the second pixel circuits PCg, and one of the first pixel circuits PCr may be sequentially arranged along a first direction (e.g., x-axis direction), and in the second row N2, one of the third pixel circuits PCb, one of the second pixel circuits PCg, one of the first pixel circuits PCr, one of the second pixel circuits PCg, and one of the third pixel circuits PCb may be sequentially arranged along a first direction (e.g., x-axis direction).

Each of the first driving voltage lines PL1 and the second driving voltage lines PL2 may extend approximately (or substantially) in the second direction (e.g., y-axis direction). The first driving voltage lines PL1 and the second driving voltage lines PL2 may be arranged alternately in each column along the first direction (e.g., x-axis direction). In an embodiment, for example, the second driving voltage lines PL2 may be arranged in odd-numbered columns (for example, the first, third and fifth columns M1, M3, and M5), and first driving voltage lines PL1 may be arranged in even-numbered columns (for example, the second and fourth M2 and M4).

Each of the first auxiliary driving voltage lines PL1a and the second auxiliary driving voltage lines PL2a may extend approximately (or substantially) in the second direction (e.g., y-axis direction). The first auxiliary driving voltage lines PL1a and the second auxiliary driving voltage lines PL2a may be arranged alternately in each row along the second direction (e.g., y-axis direction). In an embodiment, for example, first auxiliary driving voltage lines PL1a may be arranged in odd rows, and second auxiliary driving voltage lines PL2a may be arranged in even rows.

The first driving voltage line PL1 may be electrically connected to the first pixel circuit PCr and the second pixel circuit PCg through the seventh node connection electrode CNE7. The seventh node connection electrode CNE7 may electrically connected to the source region of each fifth transistor T5 (refer to FIG. 14) to the second capacitor electrode CE2 (refer to FIG. 14) of the storage capacitor Cst (refer to FIG. 14) of the pixel circuits connected to the first driving voltage line PL1, similarly to the sixth node connection electrode CNE6 illustrated in FIG. 14.

Second pixel circuits PCg may be located on the left (e.g., -x side) and right (e.g., +x side) of each first pixel circuit PCr. The second pixel circuit PCg, the first pixel circuit PCr and the second pixel circuit PCg, which are adjacent to each other, may be electrically connected to the single seventh node connection electrode CNE7. In an embodiment, for example, in the second row N2, the second pixel circuit PCg of the second column M2, the first pixel circuit PCr of the third column M3, and the second pixel circuit PCg of the fourth column M4 may be electrically connected to one of the seventh node connection electrodes CNE7.

The seventh node connection electrode CNE7 may be electrically connected to two adjacent first driving voltage lines PL1. In an embodiment, for example, in the second row N2, the seventh node connection electrode CNE7 electrically connected to the second pixel circuit PCg of the second column M2, the first pixel circuit PCr of the third column M3, and the second pixel circuit PCg of the fourth column M4 may be electrically connected to the first driving voltage line PL1 of the second column M2 and the first driving voltage line PL1 of the fourth column M4. Accordingly, the first pixel circuit PCr of the second row N2 and third column M3 may not overlap the first driving voltage line PL1, but may receive the first driving voltage ELVDD1 (refer to FIG. 7A) from the first driving voltage lines PL1 of the adjacent columns.

Among the seventh node connection electrodes CNE7, the seventh node connection electrodes CNE7 arranged in odd rows may be electrically connected to the first auxiliary driving voltage line PL1a of the same row and may be integrally formed with each other as a single unitary indivisible part. The first driving voltage lines PL1 and the first auxiliary driving voltage lines PL1a may be electrically connected through the seventh node connection electrodes CNE7 to form the second mesh structure MS2. The seventh node connection electrodes CNE7 arranged in even rows may be arranged spaced apart from the second auxiliary driving voltage line PL2a of the same row.

The second driving voltage lines PL2 may be electrically connected to the third pixel circuits PCb through an eighth node connection electrode CNE8. The eighth node connection electrode CNE8 may electrically connected to the source region of the fifth transistor T5 and the second capacitor electrode CE2 of the storage capacitor Cst of the pixel circuit corresponding to the second driving voltage lines PL2, similar to the fifth node connection electrode CNE5 illustrated in FIG. 14. Each of the third pixel circuits PCb may receive the second driving voltage ELVDD2 (refer to FIG. 7B) from a corresponding second driving voltage line PL2 through the eighth node connection electrode CNE8.

Among the eighth node connection electrodes CNE8, the eighth node connection electrodes CNE8 arranged in even rows may be connected to the second auxiliary driving voltage line PL2a of the same row and may be integrally formed with each other as a single unitary indivisible part. The second driving voltage lines PL2 and the second auxiliary driving voltage lines PL2a may be electrically connected through the eighth node connection electrodes CNE8 to form the third mesh structure MS3. The eighth node connection electrodes CNE8 arranged in odd rows may be arranged spaced apart from the first auxiliary driving voltage line PL1a of the same row.

FIG. 15B is similar to FIG. 15A, except that the second auxiliary driving voltage line PL2a is arranged in odd rows, and the first auxiliary driving voltage line PL1a is omitted. Hereinafter, any repetitive detailed descriptions of similar configurations will be omitted, and the description will focus on the differences.

The first driving voltage line PL1 may be electrically connected to the first pixel circuit PCr and the second pixel circuit PCg through the seventh node connection electrode CNE7. The second pixel circuit PCg, the first pixel circuit PCr and the second pixel circuit PCg, which are adjacent to each other, may be electrically connected to the single seventh node connection electrode CNE7.

The seventh node connection electrode CNE7 may be electrically connected to two adjacent first driving voltage lines PL1. The seventh node connection electrodes CNE7 may be arranged in a zigzag pattern in each row to electrically connect adjacent first driving voltage lines PL1 to each other. In an embodiment, for example, the first driving voltage line PL1 of the second column M2 and the first driving voltage line PL1 of the fourth column M4 may be electrically connected to each other by the seventh node connection electrodes CNE7 of even rows, and the first driving voltage line PL1 of the fourth column M4 and the first driving voltage line of the sixth column may be electrically connected to each other by the seventh node connection electrodes CNE7 of odd rows. Accordingly, in such an embodiment where the auxiliary driving voltage line extending in the first direction (e.g., x-axis direction) is omitted, adjacent first driving voltage lines PL1 may be connected to each other by the seventh node connection electrode CNE7 to form a mesh structure.

The second driving voltage lines PL2 may be electrically connected to the third pixel circuits PCb through the eighth node connection electrode CNE8. The eighth node connection electrodes CNE8 may be integrally formed with each other as a single unitary indivisible part by being connected to the second auxiliary driving voltage line PL2a of the same row. The second driving voltage lines PL2 and the second auxiliary driving voltage lines PL2a may be electrically connected to form the third mesh structure MS3.

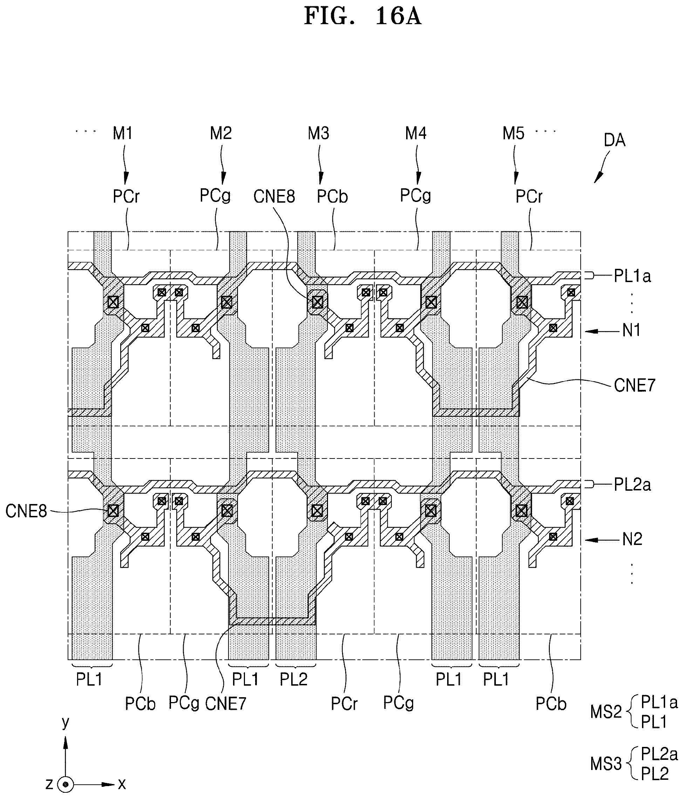

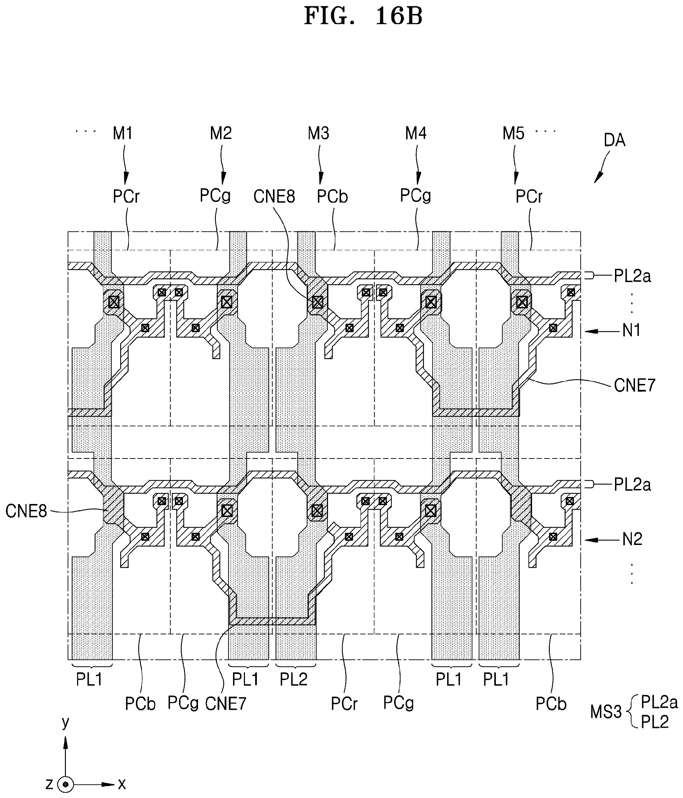

FIGS. 16A and 16B are schematic plan views, each illustrating a mesh structure of a display apparatus 1 according to an embodiment.

Referring to FIG. 16A, the first, second and third pixel circuits PCr, PCg, and PCb may be arranged in a matrix form along the first direction (e.g., x-axis direction) and the second direction (e.g., y-axis direction) in the display area DA. In FIG. 16A, the approximate boundaries of the first and second rows N1 and N2, and the first, second, third, fourth and fifth columns M1, M2, M3, M4, and M5 are drawn with dotted lines.

Each of the first driving voltage lines PL1 and the second driving voltage lines PL2 may extend approximately (or substantially) in the second direction (e.g., y-axis direction). The first driving voltage lines PL1 and the second driving voltage lines PL2 may be disposed in the first direction (e.g., x-axis direction) according to a predefined rule. In an embodiment, For example, one of the first driving voltage lines PL1, one of the first driving voltage lines PL1, one of the second driving voltage lines PL2, and one of the first driving voltage lines PL1 may be arranged repeatedly in units of four columns along the first direction (e.g., x-axis direction).

Each of the first auxiliary driving voltage lines PL1a and the second auxiliary driving voltage lines PL2a may extend approximately (or substantially) in the second direction (e.g., y-axis direction). The first auxiliary driving voltage lines PL1a and the second auxiliary driving voltage lines PL2a may be arranged alternately in each row along the second direction (e.g., y-axis direction). In an embodiment, for example, the first auxiliary driving voltage lines PL1a may be arranged in odd rows, and the second auxiliary driving voltage lines PL2a may be arranged in even rows.

The first driving voltage line PL1 may be electrically connected to the first pixel circuits PCr and the second pixel circuits PCg through the seventh node connection electrodes CNE7. The second pixel circuit PCg, the first pixel circuit PCr and the second pixel circuit PCg, which are adjacent to each other, may be electrically connected to the single seventh node connection electrode CNE7. In an embodiment, for example, in the second row N2, the second pixel circuit PCg of the second column M2, the first pixel circuit PCr of the third column M3, and the second pixel circuit PCg of the fourth column M4 may be electrically connected to the single seventh node connection electrode CNE7.

The seventh node connection electrodes CNE7 arranged in odd rows may be electrically connected to three adjacent first driving voltage lines PL1. In an embodiment, for example, in the first row N1, the seventh node connection electrode CNE7 electrically connected to the second pixel circuit PCg of the fourth column M4, the first pixel circuit PCr of the fifth column M5, and the second pixel circuit of the sixth column may be electrically connected to the first driving voltage line PL1 of the fourth column M4, the first driving voltage line PL1 of the fifth column M5, and the first driving voltage line of the sixth column.

The seventh node connection electrodes CNE7 arranged in even rows may be electrically connected to two adjacent first driving voltage lines PL1. In an embodiment, for example, in the second row N2, the seventh node connection electrode CNE7 electrically connected to the second pixel circuit PCg of the second column M2, the first pixel circuit PCr of the third column M3, and the second pixel circuit PCg of the fourth column M4 may be electrically connected to the first driving voltage line PL1 of the second column M2 and the first driving voltage line PL1 of the fourth column M4.

Among the seventh node connection electrodes CNE7, the seventh node connection electrodes CNE7 arranged in odd rows may be electrically connected to the first auxiliary driving voltage line PL1a of the same row and may be integrally formed with each other as a single unitary indivisible part. The first driving voltage lines PL1 and the first auxiliary driving voltage lines PL1a may be electrically connected through the seventh node connection electrodes CNE7 to form the second mesh structure MS2. The seventh node connection electrodes CNE7 arranged in even rows may be arranged spaced apart from the second auxiliary driving voltage line PL2a.

The second driving voltage lines PL2 may be electrically connected to the third pixel circuits PCb through the eighth node connection electrode CNE8. Among the eighth node connection electrodes CNE8, the eighth node connection electrodes CNE8 arranged in even rows may be connected to the second auxiliary driving voltage line PL2a of the same row and may be integrally formed with each other as a single unitary indivisible part. The second driving voltage lines PL2 and the second auxiliary driving voltage lines PL2a may be electrically connected to each other through the eighth node connection electrodes CNE8 to form a third mesh structure MS3. The eighth node connection electrodes CNE8 arranged in odd rows may be arranged spaced apart from the first auxiliary driving voltage line PL1a.

FIG. 16B is similar to FIG. 16A, except that the second auxiliary driving voltage line PL2a is arranged in odd rows, and the first auxiliary driving voltage line PL1a is omitted in FIG. 16B. Hereinafter, any repetitive detailed descriptions of similar configurations will be omitted, and the description will focus on the differences.

The first driving voltage line PL1 may be electrically connected to the first pixel circuit PCr and the second pixel circuit PCg through the seventh node connection electrode CNE7. The second pixel circuit PCg, the first pixel circuit PCr and the second pixel circuit PCg, which are adjacent to each other, may be electrically connected to the single seventh node connection electrode CNE7. The seventh node connection electrodes CNE7 may be arranged spaced apart from the second auxiliary driving voltage lines PL2a.

The seventh node connection electrodes CNE7 may be arranged in a zigzag pattern in each row to electrically connect adjacent first driving voltage lines PL1 to each other. In an embodiment, for example, the first driving voltage line PL1 of the second column M2 and the first driving voltage line PL1 of the fourth column M4 may be electrically connected by the seventh node connection electrodes CNE7 of even rows, and the first driving voltage line PL1 of the fourth column M4 and the first driving voltage line of the sixth column may be electrically connected by the seventh node connection electrodes CNE7 of odd rows. Accordingly, in such an embodiment where the auxiliary driving voltage line extending in the first direction (e.g., x-axis direction) is omitted, adjacent first driving voltage lines PL1 may be connected to each other by the seventh node connection electrode CNE7 to form a mesh structure.

The second driving voltage lines PL2 may be electrically connected to the third pixel circuits PCb through the eighth node connection electrode CNE8. The eighth node connection electrodes CNE8 may be integrally formed with each other as a single unitary indivisible part by being connected to the second auxiliary driving voltage line PL2a of the same row. The second driving voltage lines PL2 and the second auxiliary driving voltage lines PL2a may be electrically connected through the eighth node connection electrodes CNE8 to form the third mesh structure MS3.

The display apparatus 1 according to embodiments may be employed by various electronic devices. An electronic device according to an embodiment includes the display apparatus 1 described above, and may further include a module or device having additional functions in addition to the display apparatus 1.

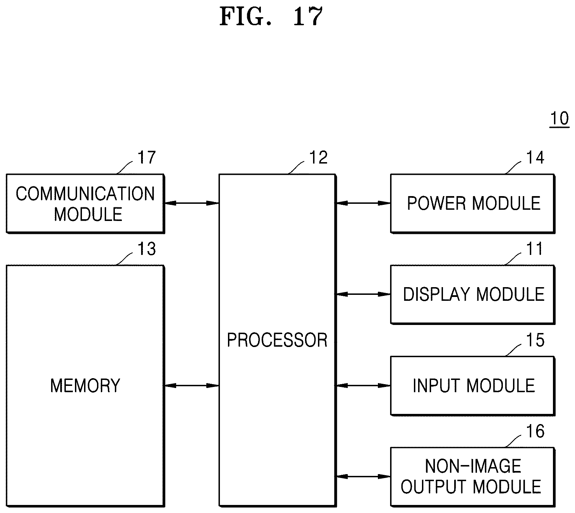

FIG. 17 is a schematic block diagram of an electronic device 10 according to an embodiment.

Referring to FIG. 17, an electronic device 10 according to an embodiment may include a display module 11, a processor 12, a memory 13, and a power module 14. The electronic device 10 may further include an input module 15, a non-image output module 16, and/or a communication module 17.

The electronic device 10 may output various information in the form of an image through the display module 11. When the processor 12 executes an application stored in the memory 13, the image information provided by the application may be provided to the user through the display module 11. The power module 14 may include a power supply module, such as a power adapter or a battery device, and a power conversion module that converts power supplied by the power supply module to generate power suitable for the operation of the electronic device 10. The input module 15 may provide input information to the processor 12 and/or the display module 11. The non-image output module 16 may receive information other than image from the processor 12, such as sound, haptics, and light, and provide the information to the user. The communication module 17 may be configured to perform transmission and reception of information between the electronic device 10 and an external device and may include a receiver and a transmitter.

In an embodiment, the processor 12 may be provided by being divided into two or more processors in a functional or structural perspective. In an embodiment, for example, the processor 12 may include a main processor as a first driving chip including a central processing unit and an auxiliary processor as a second driving chip including a controller configured to receive an image signal from the main processor and process the image signal according to the interface specifications of the display module 11.

The memory 13 may include at least one selected from non-volatile memory and volatile memory. The memory 13 may store data information necessary for operations of the processor 12 or the display module 11. When the processor 12 executes an application stored in the memory 13, an image data signal and/or an input control signal may be transmitted to the display module 11, and the display module 11 may be configured to process the received signal and output image information through a display screen.

The power module 14 may include a power supply module, such as a power adapter or a battery device, and a power conversion module that converts power supplied by the power supply module to generate power used for the operation of the electronic device 10. The power conversion by the power conversion module may include direct current (DC)-DC conversion, alternating current (AC)-DC conversion, and DC-AC conversion and is not limited thereto.

The input module 15 may provide input information to the processor 12 and/or the display module 11. The input module 15 may include not only a physical button, a keyboard, and a microphone, but also various sensor modules. Examples of sensor modules may include touch sensors, pressure sensors, distance sensors, position sensors, digitizers, motion recognition sensors, camera sensors, photodetectors, photoelectric conversion sensors, temperature sensors, as well as biosensors such as blood pressure sensors, blood sugar sensors, electrocardiogram sensors, and heart rate sensors.

The non-image output module 16 may receive information except for an image from the processor 12 and provide the information to the user. Examples of the non-image output module 16 may include a sound module, a haptic module, a light-emission module, etc. and may also include other functionally intrinsic modules (for example, a cooling module of a refrigerator, etc.) of the electronic device 10.

The communication module 17 may be configured to perform transmission and reception of information between the electronic device 10 and an external device and may include a receiver and a transmitter. The communication module 17 may include various wireless communication modules, such as a mobile communication module, a Wi-Fi^{®} module, a Bluetooth^{®} module, etc., or various wired communication modules.

At least of the components of the electronic device 10 described above may be included in the display apparatus 1 (refer to FIG. 1) according to the embodiments described above. Also, some of individual modules functionally included in one module may be included in the display apparatus 1 and the others may be provided separately from the display apparatus 1. In an embodiment, for example, the display apparatus 1 may include the display module 11, and the processor 12, the memory 13, and the power module 14 may be provided in the electronic device 10 as other devices, rather than the display apparatus 1. In an embodiment, for example, the power module 14 may be provided in the display apparatus 1 and may provide a power supply to the processor 12 and the memory 13 in the electronic device 10, rather than the display apparatus 1. However, the disclosure is not limited thereto.

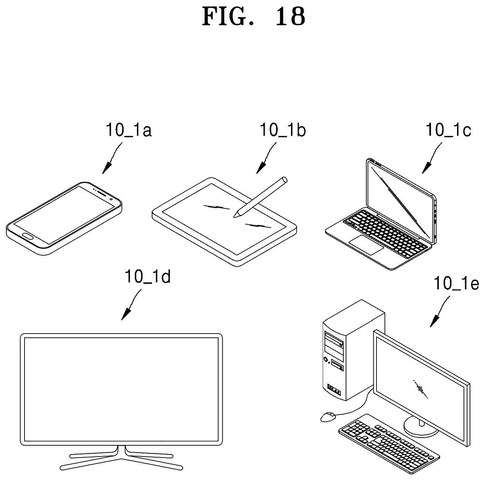

FIGS. 18, 19, and 20 are schematic diagrams of electronic devices according to various embodiments.

FIG. 18 illustrates examples of electronic devices, including a smartphone 10_1a, a tablet personal computer (PC) 10_1b, a laptop computer 10_1c, a television (TV) 10_1d, and a monitor 10_1e for a desk.

The smartphone 10_1a may include an input module, such as a touch sensor, etc., and a communication module, in addition to the display module 11. The smartphone 10_1a may process information received through the communication module or other input modules and display the processed information through a display module of the display apparatus 1.

The tablet PC 10_1b, the laptop computer 10_1c, the TV 10_1d, and the monitor 10_1e for a desk may also include a display module and an input module, similarly as the smartphone 10_1a, and may further include a communication module according to cases.

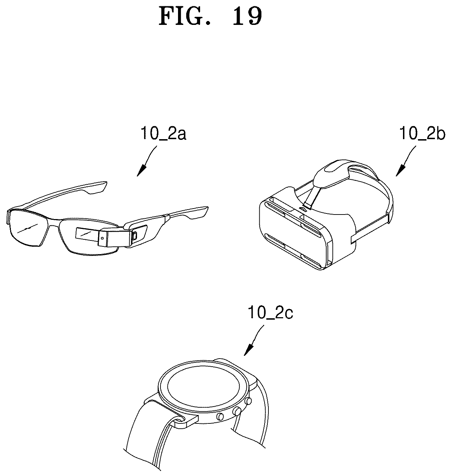

FIG. 19 illustrates examples in which an electronic device 10 including a display module 11 is employed to a wearable electronic device. The wearable electronic device may include smart glasses 10_2a, a head-mounted display (HMD) 10_2b, a smart watch 10_2c, etc.

The smart glasses 10_2a and the HMD 10_2b may include a display module configured to project a display image and a reflector configured to reflect the projected display screen and provide the display screen to a user's eye, to provide a screen of virtual reality (VR) or augmented reality (AR) to the user.

The smart watch 10_2c may include a biometric sensor as an input device and may provide biometric information recognized through the biometric sensor to the user through a display module.

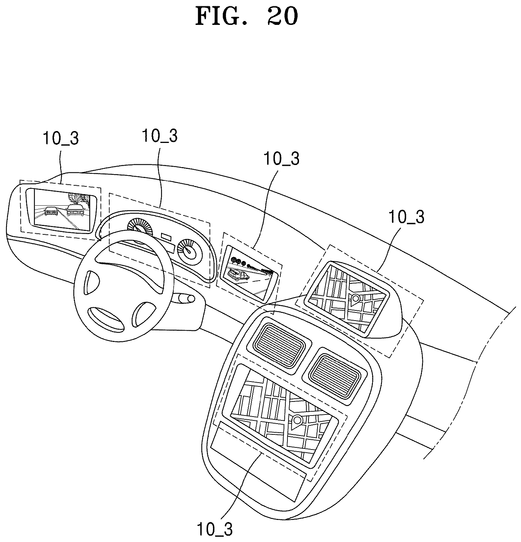

FIG. 20 illustrates examples in which an electronic device 10 including a display module 11 is employed to a vehicle. In an embodiment, for example, an electronic device 10_3 may be used as a gauge or a center fascia of the vehicle or may be used as a center information display (CID) arranged on a dashboard of the vehicle or as a room mirror display substituting a side-view mirror.

Although not shown, the electronic device employing the display apparatus 1 (refer to FIG. 1) according to embodiments may include not only devices mainly used for a screen display, such as an advertisement board, an electronic display board, a game machine, etc., but also various home appliances for displaying information through a display module, such as a refrigerator, a laundry machine, a dryer, an air conditioner, a robot cleaner, etc. Also, in an embodiment where a display module 11 is desired to have a light-transmission function, the display module may be employed by the electronic device 10, such as a smart window or a transparent display apparatus 1 for displaying a background and a display image together. Types of the electronic device 10 according to an embodiment are not limited to the examples described above, and various other electronic devices may also be provided.

According to an embodiment described above, a display apparatus capable of displaying a high-quality image and an electronic device having the same may be implemented.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the appended claims.

## Claims

1. A display apparatus (1) comprising:
a substrate (100) comprising a display area (DA), a first peripheral area (PA1) disposed on one side of the display area (DA), a second peripheral area (PA2) disposed on an opposing side of the display area (DA), and a third peripheral area (PA3) and a fourth peripheral area (PA4), wherein the third and fourth peripheral areas (PA3, PA4) connect the first peripheral area (PA1) and the second peripheral area (PA2) to each other;
first driving voltage lines (PL1) and second driving voltage lines (PL2), which are disposed in the display area (DA) and extending in a first direction;
first pixel circuits (PCr) and third pixel circuits (PCg), which are disposed in the display area (DA) and electrically connected to the first driving voltage lines (PL1);
second pixel circuits (PCb) arranged in the display area (DA) and electrically connected to the second driving voltage lines (PL2);
a first driving voltage supply line (VDDL1), a second driving voltage supply line (VDDL2) and a third driving voltage supply line (VDDL3), which are disposed in the first peripheral area (PA1) and extending in a second direction intersecting the first direction; and
a fourth driving voltage supply line (VDDL4) and a fifth driving voltage supply line (VDDL5), which are disposed in the second peripheral area (PA2) and extending in the second direction,
wherein the first driving voltage supply line (VDDL1) is electrically connected to the third driving voltage supply line (VDDL3),
the first driving voltage lines (PL1) are electrically connected to the third driving voltage supply line (VDDL3) and the fourth driving voltage supply line (VDDL4), and
the second driving voltage lines (PL2) are electrically connected to the second driving voltage supply line (VDDL2) and the fifth driving voltage supply line (VDDL5).

2. The display apparatus (1) of claim 1, further comprising second auxiliary driving voltage lines (PL2a) disposed in the display area (DA) and extending in the second direction,
wherein the second driving voltage lines (PL2) are electrically connected to the second auxiliary driving voltage lines (PL2a).

3. The display apparatus (1) of claim 2, further comprising first auxiliary driving voltage lines (PL1a) disposed in the display area (DA) and extending in the second direction,
wherein the first driving voltage lines (PL1) are electrically connected to the first auxiliary driving voltage lines (PL1a), wherein the first auxiliary driving voltage lines (PL1a) and the second auxiliary driving voltage lines (PL2a) are preferably arranged alternately in the first direction.

4. The display apparatus (1) of any one of the preceding claims,
wherein the first driving voltage lines (PL1) and the second driving voltage lines (PL2) are alternately arranged in the second direction; and/or
wherein one of the first driving voltage lines (PL1), one of the first driving voltage lines (PL1), one of the second driving voltage lines (PL2), and one of the first driving voltage lines (PL1) are repeatedly arranged in the second direction.

5. The display apparatus (1) of any one of the preceding claims, wherein a voltage level of a first driving voltage (ELVDD1) transmitted through the first driving voltage lines (PL1) is different from a voltage level of a second driving voltage (ELVDD2) transmitted through the second driving voltage lines (PL2).

6. The display apparatus (1) of any one of the preceding claims, further comprising first voltage connection electrodes (VCE2) electrically connecting the second driving voltage supply line (VDDL2) and the second driving voltage lines (PL2),
wherein the first driving voltage supply line (VDDL1), the second driving voltage supply line (VDDL2), and the third driving voltage supply line (VDDL3) are sequentially arranged in the first direction in a plan view, and
each of the first voltage connection electrodes (VCE2) is electrically connected to a corresponding one of the second driving voltage lines (PL2) through a contact hole (CNT5), and the contact hole (CNT5) is defined between the second driving voltage supply line (VDDL2) and the third driving voltage supply line (VDDL3).

7. The display apparatus (1) of any one of the preceding claims,
wherein the first driving voltage lines (PL1) are disposed in a different layer from the third driving voltage supply line (VDDL3) and in a same layer as the fourth driving voltage supply line (VDDL4); and/or
wherein the second driving voltage lines (PL2) are disposed in a same layer as the second driving voltage supply line (VDDL2) and in a different layer from the fifth driving voltage supply line (VDDL5).

8. The display apparatus (1) of any one of the preceding claims,
wherein a width (w7) of the first driving voltage supply line (VDDL1) along the first direction is different from a width (w8) of the second driving voltage supply line (VDDL2) along the first direction; and/or
wherein a width (w9) of the fourth driving voltage supply line (VDDL4) along the first direction is different from a width (w10) of the fifth driving voltage supply line (VDDL5) along the first direction.

9. The display apparatus (1) of any one of the preceding claims, further comprising:
pads disposed in the first peripheral area (PA1);
first voltage connection lines (VCL2) electrically connecting the first driving voltage supply line (VDDL1) and corresponding pads among the pads to each other; and
second voltage connection lines (VCL3) electrically connecting the second driving voltage supply line (VDDL2) and corresponding pads among the pads to each other.

10. The display apparatus (1) of claim 9, wherein the first voltage connection lines (VCL2) comprise a first sub-connection line (VCL2a, VCL2b, VCL2c),
the second voltage connection lines (VCL3) comprise a second sub-connection line (VCL3a, VCL3b, VCL3c) adjacent to the first sub-connection line (VCL2a, VCL2b, VCL2c), and
a width (w1, w3, w5) of the first sub-connection line (VCL2a, VCL2b, VCL2c) and a width (w2, w4, w6) of the second sub-connection line (VCL3a, VCL3b, VCL3c) are different from each other.

11. The display apparatus (1) of any one of the preceding claims, further comprising:
a first bottom driving voltage supply line (VBL1) disposed in the first peripheral area (PA1) and extending in the second direction;
a second bottom driving voltage supply line (VBL2) disposed in the second peripheral area (PA2) and extending in the second direction;
a third bottom driving voltage supply line (VBL3) disposed in the third peripheral area (PA3), extending in the first direction, and connected to the first bottom driving voltage supply line (VBL1) and the second bottom driving voltage supply line (VBL2); and
a fourth bottom driving voltage supply line (VBL4) disposed in the fourth peripheral area (PA4), extending in the first direction, and connected to the first bottom driving voltage supply line (VBL1) and the second bottom driving voltage supply line (VBL2).

12. The display apparatus (1) of claim 11, further comprising an auxiliary driving voltage supply line (VBLa) disposed between the second bottom driving voltage supply line (VBL2) and the display area (DA) and extending in the second direction.

13. The display apparatus (1) of claim 12, further comprising vertical voltage lines (MLv) extending from the first bottom driving voltage supply line (VBL1) to the auxiliary driving voltage supply line (VBLa); and
horizontal voltage lines (MLh) extending from the third bottom driving voltage supply line (VBL3) to the fourth bottom driving voltage supply line (VBL4) and connected to the vertical voltage lines (MLv).

14. The display apparatus (1) of any one of claims 11 to 13, wherein the third driving voltage supply line (VDDL3) is disposed on the first bottom driving voltage supply line (VBL1) and overlaps the first bottom driving voltage supply line (VBL1) in a plan view, and
the fourth driving voltage supply line (VDDL4) is disposed on the second bottom driving voltage supply line (VBL2) and overlaps the second bottom driving voltage supply line (VBL2) in a plan view.

15. An electronic device (10, 10_3) comprising:
a display apparatus (1) of any one of the preceding claims;
a memory (13) configured to store an application; and
a processor (12) configured to execute the application and to transmit an image data signal or a control signal to the display apparatus (1).

## Amended claims

### Amended claims in accordance with Rule 137(2) EPC.

1. A display apparatus (1) comprising:
a substrate (100) comprising a display area (DA), a first peripheral area (PA1) disposed on one side of the display area (DA), a second peripheral area (PA2) disposed on an opposing side of the display area (DA), and a third peripheral area (PA3) and a fourth peripheral area (PA4), wherein the third and fourth peripheral areas (PA3, PA4) connect the first peripheral area (PA1) and the second peripheral area (PA2) to each other;
first driving voltage lines (PL1) and second driving voltage lines (PL2), which are disposed in the display area (DA) and extending in a first direction;
first pixel circuits (PCr) and third pixel circuits (PCg), which are disposed in the display area (DA) and electrically connected to the first driving voltage lines (PL1);
second pixel circuits (PCb) arranged in the display area (DA) and electrically connected to the second driving voltage lines (PL2);
a first driving voltage supply line (VDDL1), a second driving voltage supply line (VDDL2) and a third driving voltage supply line (VDDL3), which are disposed in the first peripheral area (PA1) and extending in a second direction intersecting the first direction; and
a fourth driving voltage supply line (VDDL4) and a fifth driving voltage supply line (VDDL5), which are disposed in the second peripheral area (PA2) and extending in the second direction,
wherein the first driving voltage supply line (VDDL1) is electrically connected to the third driving voltage supply line (VDDL3),
the first driving voltage lines (PL1) are electrically connected to the third driving voltage supply line (VDDL3) and the fourth driving voltage supply line (VDDL4),
the first driving voltage lines (PL1) are disposed in a different layer from the third driving voltage supply line (VDDL3) and in a same layer as the fourth driving voltage supply line (VDDL4),
the second driving voltage lines (PL2) are electrically connected to the second driving voltage supply line (VDDL2) and the fifth driving voltage supply line (VDDL5), and
a voltage level of a first driving voltage (ELVDD1) transmitted through the first driving voltage lines (PL1) is different from a voltage level of a second driving voltage (ELVDD2) transmitted through the second driving voltage lines (PL2).

2. The display apparatus (1) of claim 1, further comprising second auxiliary driving voltage lines (PL2a) disposed in the display area (DA) and extending in the second direction,
wherein the second driving voltage lines (PL2) are electrically connected to the second auxiliary driving voltage lines (PL2a).

3. The display apparatus (1) of claim 2, further comprising first auxiliary driving voltage lines (PL1a) disposed in the display area (DA) and extending in the second direction,
wherein the first driving voltage lines (PL1) are electrically connected to the first auxiliary driving voltage lines (PL1a), wherein the first auxiliary driving voltage lines (PL1a) and the second auxiliary driving voltage lines (PL2a) are preferably arranged alternately in the first direction.

4. The display apparatus (1) of any one of the preceding claims,
wherein the first driving voltage lines (PL1) and the second driving voltage lines (PL2) are alternately arranged in the second direction; and/or
wherein one of the first driving voltage lines (PL1), one of the first driving voltage lines (PL1), one of the second driving voltage lines (PL2), and one of the first driving voltage lines (PL1) are repeatedly arranged in the second direction.

5. The display apparatus (1) of any one of the preceding claims, further comprising first voltage connection electrodes (VCE2) electrically connecting the second driving voltage supply line (VDDL2) and the second driving voltage lines (PL2),
wherein the first driving voltage supply line (VDDL1), the second driving voltage supply line (VDDL2), and the third driving voltage supply line (VDDL3) are sequentially arranged in the first direction in a plan view, and
each of the first voltage connection electrodes (VCE2) is electrically connected to a corresponding one of the second driving voltage lines (PL2) through a contact hole (CNT5), and the contact hole (CNT5) is defined between the second driving voltage supply line (VDDL2) and the third driving voltage supply line (VDDL3).

6. The display apparatus (1) of any one of the preceding claims,
wherein the second driving voltage lines (PL2) are disposed in a same layer as the second driving voltage supply line (VDDL2) and in a different layer from the fifth driving voltage supply line (VDDL5).

7. The display apparatus (1) of any one of the preceding claims,
wherein a width (w7) of the first driving voltage supply line (VDDL1) along the first direction is different from a width (w8) of the second driving voltage supply line (VDDL2) along the first direction; and/or
wherein a width (w9) of the fourth driving voltage supply line (VDDL4) along the first direction is different from a width (w10) of the fifth driving voltage supply line (VDDL5) along the first direction.

8. The display apparatus (1) of any one of the preceding claims, further comprising:
pads disposed in the first peripheral area (PA1);
first voltage connection lines (VCL2) electrically connecting the first driving voltage supply line (VDDL1) and corresponding pads among the pads to each other; and
second voltage connection lines (VCL3) electrically connecting the second driving voltage supply line (VDDL2) and corresponding pads among the pads to each other.

9. The display apparatus (1) of claim 8, wherein the first voltage connection lines (VCL2) comprise a first sub-connection line (VCL2a, VCL2b, VCL2c),
the second voltage connection lines (VCL3) comprise a second sub-connection line (VCL3a, VCL3b, VCL3c) adjacent to the first sub-connection line (VCL2a, VCL2b, VCL2c), and
a width (w1, w3, w5) of the first sub-connection line (VCL2a, VCL2b, VCL2c) and a width (w2, w4, w6) of the second sub-connection line (VCL3a, VCL3b, VCL3c) are different from each other.

10. The display apparatus (1) of any one of the preceding claims, further comprising:
a first bottom driving voltage supply line (VBL1) disposed in the first peripheral area (PA1) and extending in the second direction;
a second bottom driving voltage supply line (VBL2) disposed in the second peripheral area (PA2) and extending in the second direction;
a third bottom driving voltage supply line (VBL3) disposed in the third peripheral area (PA3), extending in the first direction, and connected to the first bottom driving voltage supply line (VBL1) and the second bottom driving voltage supply line (VBL2); and
a fourth bottom driving voltage supply line (VBL4) disposed in the fourth peripheral area (PA4), extending in the first direction, and connected to the first bottom driving voltage supply line (VBL1) and the second bottom driving voltage supply line (VBL2).

11. The display apparatus (1) of claim 10, further comprising an auxiliary driving voltage supply line (VBLa) disposed between the second bottom driving voltage supply line (VBL2) and the display area (DA) and extending in the second direction.

12. The display apparatus (1) of claim 11, further comprising vertical voltage lines (MLv) extending from the first bottom driving voltage supply line (VBL1) to the auxiliary driving voltage supply line (VBLa); and
horizontal voltage lines (MLh) extending from the third bottom driving voltage supply line (VBL3) to the fourth bottom driving voltage supply line (VBL4) and connected to the vertical voltage lines (MLv).

13. The display apparatus (1) of any one of claims 10 to 12, wherein the third driving voltage supply line (VDDL3) is disposed on the first bottom driving voltage supply line (VBL1) and overlaps the first bottom driving voltage supply line (VBL1) in a plan view, and
the fourth driving voltage supply line (VDDL4) is disposed on the second bottom driving voltage supply line (VBL2) and overlaps the second bottom driving voltage supply line (VBL2) in a plan view.

14. An electronic device (10, 10_3) comprising:
a display apparatus (1) of any one of the preceding claims;
a memory (13) configured to store an application; and
a processor (12) configured to execute the application and to transmit an image data signal or a control signal to the display apparatus (1).
